# EUROPEAN PATENT APPLICATION

(11) **EP 1 458 094 A1**
(43) Date of publication of application: **15.09.2004**
(21) Application number: 03771285.8
(22) Date of filing: 23.07.2003
(51) Int. Cl.: H03H 9/02, H03H 9/17, H03H 9/25, H03H 3/08

(54) **PIEZOELECTRIC COMPONENT AND PRODUCTION METHOD THEREFOR**

(30) Priority: 31.07.2002 JP 2002222600; 16.07.2003 JP 2003198048
(71) Applicant: Murata Manufacturing Co., Ltd., Nagaokakyo-shi Kyoto-fu 617-8555 (JP)
(72) Inventor: KOSHIDO, Y.; c/o MURATA MANUFACTURING CO., LTD., Nagaokakyo-shi, Kyoto 617-8555 (JP)
(74) Representative: Thévenet, Jean-Bruno
(86) International application number: PCT/JP2003/009311
(87) International publication number: WO 2004/012330

(57) **Abstract**

A piezoelectric part which can be reduced in size, and further which has improved degree of freedom regarding the position of external terminals, and a manufacturing method thereof, are provided. A surface acoustic wave device comprises a SAW element 6 having an IDT 2 formed on a piezoelectric substrate and electroconductive pads 3 connected to the IDT 2, and a bonding board 20 having electroconductive pad through holes 18, bonded by an adhesive layer 21, so as to face the IDT 2. Protective space is formed by an excitation portion protecting hollow structure 16 for protecting surface acoustic wave excitation portion such as the IDT 2 is formed. Also, external terminals 22 connected to the electroconductive pads 3 through the electroconductive pad through holes 18 are at positions offset from the electroconductive pad through holes 18.

## Description

### Technical Field

The present invention relates to a piezoelectric part such as: a surface acoustic wave device used in delay lines, filters, and so forth; a piezoelectric thin-film filter; and so forth; and to a manufacturing method thereof, and particularly relates to a chip-size packaged piezoelectric part and a manufacturing method thereof.

### Background Art

Reduction in size and weight of electronic apparatuses in recent years has led to demand for increased functions of electronic parts. In such a background, there is similar demand for reduction in size and weight of piezoelectric parts, such as surface acoustic wave filters (hereafter referred to as SAW filters) serving as surface acoustic wave devices used for communication devices such as cellular telephones and the like, and piezoelectric filters using piezoelectric thin-film resonators.

A piezoelectric filter comprises a piezoelectric resonator having a Si substrate with openings or recesses, and a vibrating portion with a structure wherein the upper and lower faces of a thin film portion having at least one or more layers of piezoelectric thin film (e.g., formed of ZnO or AIN) formed on the openings or recesses are sandwiched between at least one pair of an upper electrode and a lower electrode facing one another, or piezoelectric resonator wherein a Si substrate does not have openings or recesses, and a space is formed between the lower electrode and the Si substrate, the piezoelectric resonator being configured in a ladder or lattice form. With such piezoelectric filters, thickness-direction-wise longitudinal vibrations occurring at the vibrating portion are used, so vibrating space must be ensured, and also the vibrating portion must be protected from moisture, dust, and so forth.

Also, surface acoustic wave filters are configured of a pair of toothcomb electrodes (inter-digital transducer, hereafter abbreviated as IDT) formed of a metal such as Al or the like on a piezoelectric substrate such as quartz, LiTaO₃, LiNbO₃, or the like. With such surface acoustic wave filters so vibrating space must be ensured at the toothcomb electrodes and piezoelectric substrate where the surface acoustic waves are propagated, and also the toothcomb electrodes must be protected from moisture, dust, and so forth.

With the aforementioned piezoelectric filters and surface acoustic wave filters, a die bonding agent is applied to the bottom face of a package formed of a ceramic such as alumina, the piezoelectric filter and surface acoustic wave filter element being mounted to the package by wire bonding, and terminals within the package and element electrodes connected by die bonding, following which the package is sealed with a lid. Also, in order to reduce size, an arrangement has also been carried out with the piezoelectric filter and surface acoustic wave filter wherein electrode lands are formed on the bottom face of the package formed of alumina or the like, with the piezoelectric filter and surface acoustic wave filter elements being mounted to the package by die bonding by flip-chip bonding, and the package being sealed with a lid.

However, the above-described structure has the problem in that, even in the event that the piezoelectric filter and surface acoustic wave filter elements are reduced in size, the piezoelectric filter and surface acoustic wave filter cannot be reduced in size and height unless the package is reduced in size. Also, there has been the problem that reducing the size of the package is expensive. Further, the vibrating portions of the piezoelectric filter in particular are formed at openings or recesses of the substrate, so there has been the problem of the vibrating portion being destroyed by application of shock in the steps of dicing the element, picking up the element for mounting, die bonding, and so forth.

In comparison, Patent Publication 1, Patent Publication 2, and Patent Publication 3, for example, describe mounting with bumps. According to these publications, a SAW filter can be reduced in size by doing away with the space necessary for wiring bonding by flip-chip bonding wherein bumps formed on a base board and the SAW element are bonded. However, electroconductive pads matching the bumps must be formed on the SAW element, and the valid area of the SAW element is reduced, so reduction in size is difficult. Also, forming bumps increases costs.

Accordingly, with Patent Publication 4, the SAW element is mounted on a base board with through holes formed therein facing the extraction electrodes of the SAW element, and an electroconductive agent is filled in the through holes, thereby forming an external circuit connection portion. Thus, the SAW filter is reduced in size.
[Patent Document 1]
   Japanese Unexamined Patent Application Publication No. 2001-94390
[Patent Document 2]
   Japanese Unexamined Patent Application Publication No. 11-150441
[Patent Document 3]
   Japanese Unexamined Patent Application Publication No. 2001-60642
[Patent Document 4]
   Japanese Unexamined Patent Application Publication No. 2001-244785

### Disclosure of Invention

However, with the configuration described in Patent Document 4, the extraction electrodes of the SAW element and the through holes in the base board are always at positions facing one another, so the positions of the external terminals formed at the through holes are fixed. Accordingly, there is a problem in that the position of the external terminals cannot be changed.

The present invention has been made in light of the above-described problems of the conventional art, and accordingly, it is an object thereof to provide a surface acoustic wave element which can be reduced in size, and further with an improved degree of freedom regarding the position of external terminals, and to a manufacturing method thereof.

In order to solve the above problems, the piezoelectric part according to the present invention is a piezoelectric part wherein a piezoelectric element having at least one vibrating portion formed on a substrate and element wiring connected to the vibrating portion, and a bonding board having through holes, are bonded by an adhesive layer, so as to face the vibrating portion, the piezoelectric part comprising: protective space for the vibrating portion; wherein external terminals connected to the element wiring via external terminal connecting material formed in the through holes are at positions offset from the through holes.

According to the above-described configuration, protective space is provided for protecting the vibrating portion, so components which increase the size of the piezoelectric parts, such as bumps, wires, etc., are unnecessary, so the corresponding space can be eliminated, and a piezoelectric part which has been reduced in size can be readily provided. Also, the position of the external terminals is offset from the through holes, i.e., offset from the position of the element wiring. That is to say, the position of the external terminals can be formed at arbitrary positions, thereby improving the degree of freedom regarding the position. Accordingly, a piezoelectric part wherein connection to external circuits can be readily performed, can be provided.

Further, in order to solve the above problems, the piezoelectric part according to the present invention is a piezoelectric part wherein a piezoelectric element having at least one vibrating portion formed on a substrate and element wiring connected to the vibrating portion, and a bonding board having through holes, are bonded by an adhesive layer, so as to face the vibrating portion, the piezoelectric part comprising: protective space for the vibrating portion; and first wiring between the adhesive layer and bonding board which is connected to the element wiring, wherein the first wiring and external terminals are connected via external terminal connecting material formed in the through holes.

According to the above configuration, the element wiring and the external terminals are connected via the first wiring and the external terminal connecting material, so the external terminals can be formed at arbitrary positions according to the position of the first wiring and the external terminal connecting material, thereby improving the degree of freedom with regard to position. Accordingly, connection with external circuits can be readily performed.

With the piezoelectric part according to the present invention, the first wiring preferably has either capacitance or an inductor, in addition to the above configuration. This does away with the need to separately provide capacitance or an inductor, and the size of the piezoelectric part can be reduced.

Further, in order to solve the above problems, the piezoelectric part according to the present invention is a piezoelectric part wherein a piezoelectric element having at least one vibrating portion formed on a substrate and element wiring connected to the vibrating portion, and a bonding board having through holes, are bonded by an adhesive layer, so as to face the vibrating portion, the piezoelectric part comprising: protective space for the vibrating portion; second wiring on the bonding board connected to the element wiring; and an upper insulating layer having insulating layer openings on the bonding board such that a part of the second wiring is exposed; wherein the second wiring and external terminals formed on the upper insulating layer are connected via external terminal connecting material formed in the insulating layer openings.

According to the above configuration, the element wiring and the external terminals are connected via the second wiring and the external terminal connecting material, so the external terminals can be formed at arbitrary positions according to the position of the second wiring and the external terminal connecting material, thereby improving the degree of freedom with regard to position. Accordingly, connection with external circuits can be readily performed.

With the piezoelectric part according to the present invention, in addition to the above configuration, the second wiring preferably has either capacitance or an inductor. This does away with the need to separately provide capacitance or an inductor, and the size of the piezoelectric part can be reduced.

With the piezoelectric part according to the present invention, in addition to the above configuration, the protective space is preferably ensured by the thickness of the adhesive layer.

With the piezoelectric part according to the present invention; in addition to the above configuration, the protective space is preferably a recess formed in the face of the bonding board facing the vibrating portions.

Also, with the piezoelectric part according to the present invention, in addition to the above configuration, the adhesive layer is preferably formed of one of thermal setting resin, thermoplastic resin, and ultraviolet setting resin.

Also, the adhesive layer is preferably formed of an adhesive agent, and further comprises a resin or metal layer between the adhesive layer formed of the adhesive agent, and the surface acoustic wave element.

Also, the bonding board is preferably formed of a material which can be wet-etched, such as glass, quartz, fused silica, or the like.

Also, the piezoelectric element is preferably a surface acoustic wave element having vibrating portions formed of toothcomb-shaped electrodes formed on a substrate.

Also, the piezoelectric element may be a piezoelectric thin-film element having a vibrating portion with a structure wherein the upper and lower faces of a thin film portion having at least one or more layers of piezoelectric thin film, formed on the openings or recesses of a substrate having openings or recesses, are sandwiched between at least one pair of an upper electrode and a lower electrode facing each other.

Also, the piezoelectric element may be a piezoelectric thin-film element having a vibrating portion with a structure wherein the upper and lower faces of a thin film portion having at least one or more layers of piezoelectric thin film, formed on a substrate, are sandwiched between at least one pair of an upper electrode and a lower electrode facing each other, and having a space between the substrate and the lower electrode at the vibrating portion.

In order to solve the above problems, method for manufacturing the piezoelectric part according to the present invention is a method for manufacturing a piezoelectric part wherein a piezoelectric element having at least one vibrating portion formed on a substrate and element wiring connected to the vibrating portion, and a bonding board having through holes, are bonded by an adhesive layer, so as to face the vibrating portion, the method comprising: a step for forming at least one vibrating portion on the substrate and element wiring connected to the vibrating portion to fabricate a piezoelectric element; a step for forming through holes in the bonding board; a step for bonding the piezoelectric element and the bonding board so as to ensure protective space for the vibrating portion with the adhesive layer; a step for forming external terminal connection material to be connected to the element wiring via the through holes; and a step for forming external terminals to be connected to the external terminal connection material.

Also, in addition to the above-described method, in the step for bonding the piezoelectric element and the bonding board so as to ensure protective space for the toothcomb electrodes with the adhesive layer, positioning is preferably performed for the element wiring and the through holes.

Further, in order to solve the above problems, the method for manufacturing a piezoelectric part according to the present invention is a method for manufacturing a piezoelectric part wherein a piezoelectric element having at least one vibrating portion formed on a substrate and element wiring connected to the vibrating portion, and a bonding board having through holes, are bonded by an adhesive layer, so as to face the vibrating portion, the method comprising: a step for forming at least one vibrating portion on the substrate and element wiring connected to the vibrating portion to fabricate a piezoelectric element; a step for bonding the piezoelectric element and the bonding board so as to ensure protective space for the vibrating portion with the adhesive layer; a step for forming through holes in the bonding board; a step for forming external terminal connection material to be connected to the element wiring via the through holes; and a step for forming external terminals to be connected to the external terminal connection material.

According to the above-described method, the protective space is provided, so components which increase the size of the piezoelectric parts, such as bumps, wires, etc., are unnecessary, so the corresponding space can be eliminated, and a piezoelectric part which has been reduced in size can be readily provided. Further, steps for forming the bumps, the electroconductive pads corresponding therewith, wire bonding, and so forth, are unnecessary, so the steps can be simplified. Also, the position of the external terminals can be formed at arbitrary positions, thereby improving the degree of freedom regarding the position. Accordingly, connection to external circuits can be readily made.

With the method for manufacturing a piezoelectric part according to the present invention, in addition to the above-described method, recesses are preferably formed on the bonding board so as to ensure protective space of the vibrating portion. Thus, space for protecting the vibrating portion can be readily formed.

Also, with the method for manufacturing a piezoelectric part according to the present invention, in addition to the above-described method, the through holes are preferably formed by wet etching using a resist pattern. Thus, the through holes can be readily formed.

Also, with the method for manufacturing a piezoelectric part according to the present invention, in addition to the above-described method, the through holes may be formed by laser etching or sand blasting processing. Thus, the through holes can be readily formed.

Also, with the method for manufacturing a piezoelectric part according to the present invention, in addition to the above-described method, the external terminal connection material and/or external terminals may be formed by metal vapor deposition.

Also, with the method for manufacturing a piezoelectric part according to the present invention, in addition to the above-described method, the external terminal connection material and/or external terminals may be formed by printing an electroconductive paste and then baking.

Also, with the method for manufacturing a piezoelectric part according to the present invention, in addition to the above-described method, the external terminals may be formed by printing an electroconductive paste in through holes, with wiring then being formed with electroconductive paste.

Also, with the method for manufacturing a piezoelectric part according to the present invention, in addition to the above-described method, a group substrate having a plurality of the piezoelectric elements is preferably formed, with bonding board being bonded to the group substrate, and then diced.

According to the above configuration, there is almost no positional offset between the bonding board and the piezoelectric element, and piezoelectric parts with good quality can be readily mass-produced.

The bonding board is preferably smaller than the group substrate. Accordingly, the offset due to difference in thermal expansion between the SAW elements and bonding board at the time of bonding can be further reduced, and high-quality piezoelectric parts can be manufactured.

Also, the piezoelectric element may be a surface acoustic wave element having vibrating portions formed of toothcomb-shaped electrodes formed on a substrate.

Also, the piezoelectric element may be a piezoelectric thin-film element having a vibrating portion with a structure wherein the upper and lower faces of a thin film portion having at least one or more layers of piezoelectric thin film, formed on the openings or recesses of a substrate having openings or recesses, are sandwiched between at least one pair of an upper electrode and a lower electrode facing each other.

Also, the piezoelectric element may be a piezoelectric thin-film element having a vibrating portion with a structure wherein the upper and lower faces of a thin film portion having at least one or more layers of piezoelectric thin film, formed on a substrate, are sandwiched between at least one pair of an upper electrode and a lower electrode facing each other, and having a space between the substrate and the lower electrode at the vibrating portion.

The piezoelectric part according to the present invention can be reduced in size, and further, the external terminals can be formed at arbitrary positions, so the degree of freedom regarding the position can be improved. Accordingly, a piezoelectric part, wherein connection to external circuits can be readily performed, can be provided.

### Brief Description of the Drawings

Fig. 1 is a cross-sectional diagram illustrating manufacturing steps of a surface acoustic wave device according to a first embodiment of the present invention.
Fig. 2 is a cross-sectional diagram illustrating manufacturing steps of a surface acoustic wave device according to the first embodiment of the present invention.
Fig. 3 is a cross-sectional diagram illustrating manufacturing steps of a surface acoustic wave device according to the first embodiment of the present invention.
Fig. 4 is a cross-sectional diagram illustrating manufacturing steps of a surface acoustic wave device according to a second embodiment of the present invention.
Fig. 5 is a cross-sectional diagram illustrating manufacturing steps of a surface acoustic wave device according to the second embodiment of the present invention.
Fig. 6 is a cross-sectional diagram illustrating manufacturing steps of a surface acoustic wave device according to the second embodiment of the present invention.
Fig. 7 is a cross-sectional diagram illustrating manufacturing steps of a surface acoustic wave device according to a third embodiment of the present invention.
Fig. 8 is a cross-sectional diagram illustrating manufacturing steps of a surface acoustic wave device according to a fourth embodiment of the present invention.
Fig. 9 is a cross-sectional diagram illustrating manufacturing steps of a surface acoustic wave device according to a fifth embodiment of the present invention.
Fig. 10 is a cross-sectional diagram illustrating manufacturing steps of a surface acoustic wave device according to the fifth embodiment of the present invention.
Fig. 11 is a cross-sectional diagram illustrating manufacturing steps of a surface acoustic wave device according to a sixth embodiment of the present invention.
Fig. 12 is a cross-sectional diagram illustrating manufacturing steps of a surface acoustic wave device according to the sixth embodiment of the present invention.
Fig. 13 is a circuit diagram of a surface acoustic wave device as a specific example of the first embodiment of the present invention.
Fig. 14 is a plan view of a surface acoustic wave element in a surface acoustic wave device as a specific example of the first embodiment of the present invention.
Fig. 15 is a plan view following forming a resin layer on the surface acoustic wave element shown in Fig. 14.
Fig. 16 is a plan view following attaching a bonding board and forming external terminals on the resin layer shown in Fig. 15.
Fig. 17 is a cross-sectional diagram of a surface acoustic wave device as a specific example of the first embodiment of the present invention.
Fig. 18 is a circuit diagram of a surface acoustic wave device as a specific example of the second embodiment of the present invention.
Fig. 19 is a plan view of a surface acoustic wave element in a surface acoustic wave device as a specific example of the second embodiment of the present invention.
Fig. 20 is a plan view following forming a resin layer on the surface acoustic wave element shown in Fig. 19.
Fig. 21 is a plan view following attaching a bonding board and forming external terminals on the resin layer shown in Fig. 20.
Fig. 22 is a cross-sectional diagram of a surface acoustic wave device as a specific example of the second embodiment of the present invention.
Fig. 23 is a circuit diagram of a surface acoustic wave device as a specific example of the sixth embodiment of the present invention.
Fig. 24 is a plan view of a surface acoustic wave element in a surface acoustic wave device as a specific example of the sixth embodiment of the present invention.
Fig. 25 is a plan view following forming a resin layer on the surface acoustic wave element shown in Fig. 24.
Fig. 26 is a plan view following forming first wiring on the resin layer shown in Fig. 25.
Fig. 27 is a plan view following attaching a bonding board and forming external terminals on the resin layer shown in Fig. 26.
Fig. 28 is a cross-sectional diagram of a surface acoustic wave device as a specific example of the sixth embodiment of the present invention.
Fig. 29 is a cross-sectional diagram illustrating a surface acoustic wave element which is a modification of the surface acoustic wave element shown in Fig. 28.
Fig. 30 is a circuit diagram of a surface acoustic wave element as another specific example of the sixth embodiment of the present invention.
Fig. 31 is a plan view of a surface acoustic wave element in another surface acoustic wave element as a specific example of the sixth embodiment of the present invention.
Fig. 32 is a plan view following forming a resin layer on the surface acoustic wave element shown in Fig. 31.
Fig. 33 is a plan view following forming first wiring and wiring on the resin layer shown in Fig. 32.
Fig. 34 is a plan view following attaching a bonding board and forming external terminals on the resin layer shown in Fig. 33.
Fig. 35 is a circuit diagram of a surface acoustic wave device as a specific example of a seventh embodiment of the present invention.
Fig. 36 is a plan view of a surface acoustic wave element in a surface acoustic wave device as a specific example of the seventh embodiment of the present invention.
Fig. 37 is a plan view following forming a resin layer on the surface acoustic wave element shown in Fig. 36.
Fig. 38 is a plan view following attaching a bonding board on the resin layer shown in Fig. 37.
Fig. 39 is a plan view following forming second wiring on the bonding board shown in Fig. 38.
Fig. 40 is a plan view following forming an upper resin layer on the bonding board shown in Fig. 38, and forming external terminals.
Fig. 41 is a cross-sectional diagram of a surface acoustic wave element in a surface acoustic wave device as a specific example of the seventh embodiment of the present invention.
Fig. 42 is a cross-sectional diagram illustrating a surface acoustic wave element which is a modification of the surface acoustic wave element shown in Fig. 41.
Fig. 43 is a circuit diagram of a surface acoustic wave element as another specific example of the seventh embodiment of the present invention.
Fig. 44 is a plan view of a surface acoustic wave element in a surface acoustic wave device as another specific example of the seventh embodiment of the present invention.
Fig. 45 is a plan view following forming a resin layer on the surface acoustic wave element shown in Fig. 44.
Fig. 46 is a plan view following attaching a bonding board on the resin layer shown in Fig. 45, and forming second wiring.
Fig. 47 is a plan view following forming an upper resin layer on the bonding board shown in Fig. 46, and forming external terminals.
Fig. 48 is a cross-sectional diagram of a surface acoustic wave element as another specific example of the seventh embodiment of the present invention.
Fig. 49 is a circuit diagram of a piezoelectric thin-film filter as a specific example of an eighth embodiment of the present invention.
Fig. 50 is a plan view of a piezoelectric thin-film element in a piezoelectric thin-film filter as a specific example of the eighth embodiment of the present invention.
Fig. 51 is a cross-sectional view of the piezoelectric thin-film element shown in Fig. 50.
Fig. 52 is a plan view following forming a resin layer on the piezoelectric thin-film element shown in Fig. 50.
Fig. 53 is a plan view following attaching a bonding board on the resin layer shown in Fig. 52, and forming second wiring.
Fig. 54 is a plan view following forming au upper resin layer on the bonding board shown in Fig. 53, and forming external terminals.
Fig. 55 is a cross-sectional diagram of a piezoelectric thin-film filter as a specific example of the eighth embodiment of the present invention.
Fig. 56 is a cross-sectional diagram illustrating a piezoelectric thin-film filter which is a modification of the piezoelectric thin-film filter shown in Fig. 55.

### Best Mode for Carrying Out the Invention

### [First Embodiment]

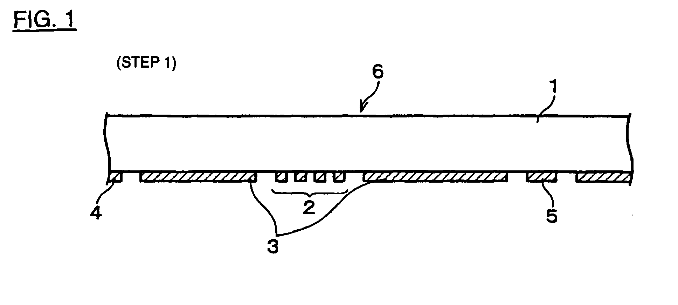

The first embodiment of the present invention will now be described with reference to Fig. 1 through Fig. 3, Fig. 13, and Fig. 17.

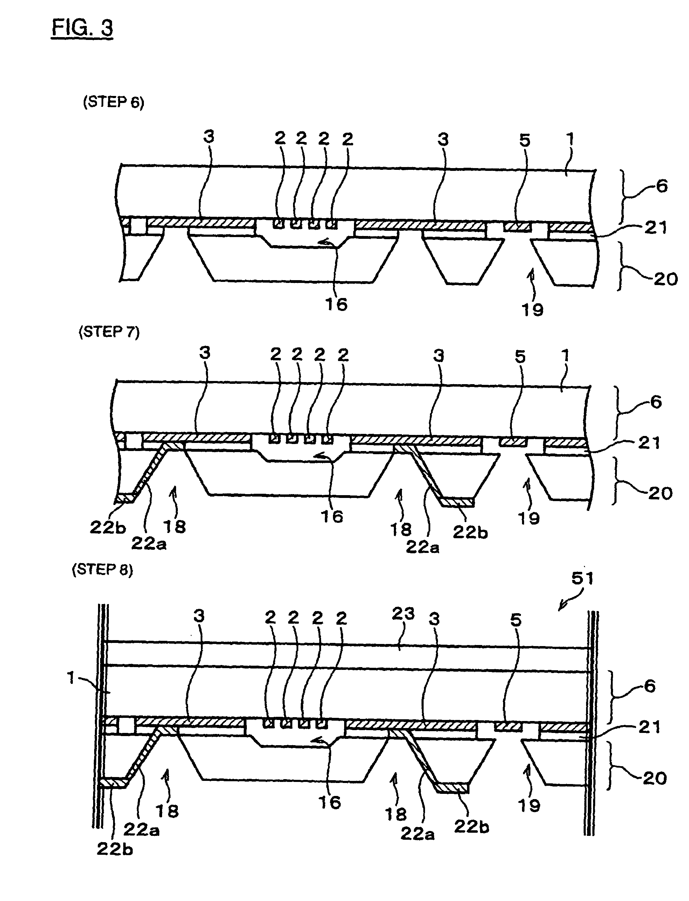

With the present embodiment, a SAW filter 51 wherein a SAW element (piezoelectric element) 6 and a bonding board 20 are bonded together with an adhesive layer 21 into a chip-size package will be described, as shown in Fig. 3. The SAW element 6 has at least an IDT (vibrating portion) 2 and electroconductive pads (element wiring) 3 on the face facing the bonding board 20. The bonding board 20 has an excitation portion protecting hollow structure (recess) 16 for protecting the excitation portion for surface acoustic waves of the IDT 2 and the like for the time of bonding with the SAW element 6 (to prevent the IDT and the bonding board from coming into contact), on the side facing the WAS element 6. The excitation portion protecting hollow structure 16 and the thickness of the adhesive layer 21 ensure space for protecting the excitation portion for surface acoustic waves of the IDT 2 and the like of the SAW element 6. Also, the excitation portion protecting hollow structure 16 enables the height of the SAW filter to be reduced. Further, electroconductive pad through holes 18 for external connection of the electroconductive pads 3 of the SAW element 6 are formed in the bonding board 20, and external terminal connection material (extraction wiring) 22a is formed, connected with external terminals 22b via the electroconductive pad through holes 18. The external terminal connection material 22a is connected with the electroconductive pads 3 via the electroconductive pad through holes 18 on a face of the bonding board other than that on which the recess is formed, and can be formed according to the position of external terminals 22b arbitrarily changed according to the circuit or the like with which external connection is to be made. That is to say, the degree of freedom of the position of the external terminals 22b can be improved. Also, also, formation of the external terminals 22b may be before, after, or simultaneous with formation of the external terminal connection material 22a.

The following is a detailed description of the manufacturing method of the aforementioned SAW filter with reference to Fig. 1 through Fig. 3.

First, as shown in Fig. 1, in Step 1, the SAW element 6 is fabricated. The IDT 2, electroconductive pads 3, reflectors (not shown), and wiring (not shown), and the like, are formed on a LiTaO₃ piezoelectric substrate 1, which is 0.35 mm thick and 100 mm in diameter, for example. That is to say, the IDT 2, electroconductive pads 3, reflectors, and lead wiring, and the like, are formed of Al for example, on a LiTaO₃ piezoelectric substrate 1, by the lift-off method or the like using vapor deposition. Thus, the SAW element 6 is fabricated. Also, at the time of the lift-off using vapor deposition, a frame is preferably formed following the perimeter of the SAW chip (dicing line), so as to serve as a base for an airtight sealing outer frame 4 at the time of applying to the later-described bonding board. Also, the dicing line may be made heavier so as to also serve as the airtight sealing outer frame. Further, alignment marks 5 may also be formed for positioning at the time of bonding to the later-described bonding board. While the shape and size of the alignment marks 5 are not restricted in particular, 10 µm round shapes will be used here. Also, though only one SAW element 6 is illustrated in Fig. 1, this may be a group substrate wherein multiple SAW elements 6 are provided on the piezoelectric substrate 1.

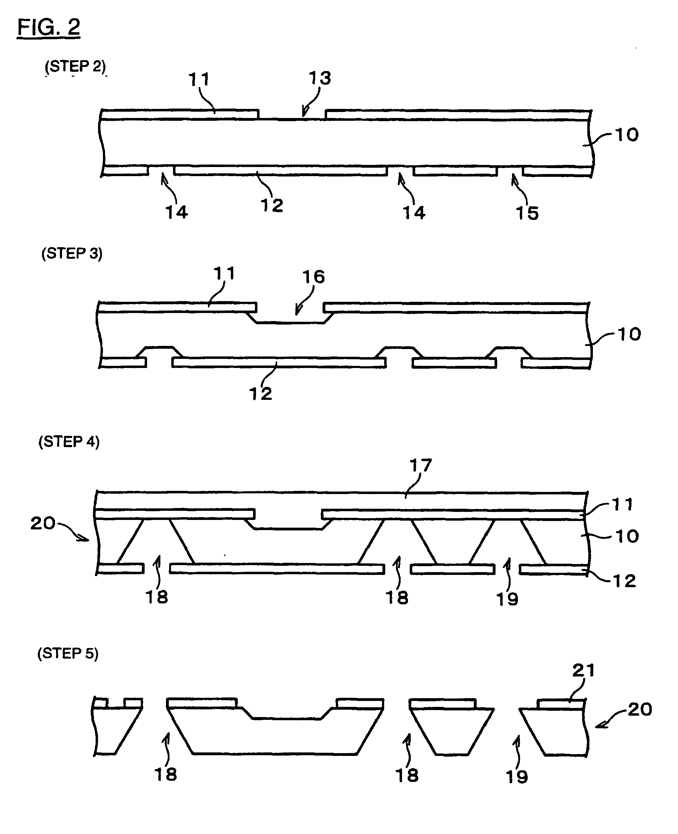

Next, the bonding board 20 is fabricated in Step 2 through Step 5, as shown in Fig. 2.

In Step 2, a resist pattern 11, having an opening 13 for forming a hollow structure aimed at protecting the excitation portion for surface acoustic waves of the IDT 2 and the like, is formed on one face (the face facing the face of the LiTaO₃ piezoelectric substrate 1 on which the IDT is formed (hereafter referred to as face A)) of a glass substrate 10 which is 0.10 mm thick and 100 mm in diameter, for example.

Further, a resist pattern 12 having openings 14 for forming through holes aimed at external connection of the electroconductive pads 3 and an opening 15 for an alignment mark, is formed on the other face of the glass substrate 10 (hereafter referred to as face B). Here, the opening 15 for the alignment mark is formed in a round shape to match the alignment mark 5, and further, matches the center of the alignment mark 5.

Next, in Step 3, both faces of the glass substrate 10 are half-etched by 30 µm for example, with hydrofluoric acid or the like. This forms the excitation portion protecting hollow structure 16.

Next, in Step 4, a resist pattern 17 is applied to the entire face of the face A of the glass substrate 10, to protect the excitation portion protecting hollow structure 16. Further, through etching is performed with hydrofluoric acid or the like on the face B of the glass substrate 10 following the resist pattern 12, thereby forming the electroconductive pad through holes 18 and alignment mark through hole 19. At this time, through etching is performed from one side, so electroconductive pad through holes 18 and alignment mark through hole 19 are formed in a tapered shape. Subsequently, the resist patterns 11, 12, and 17 are peeled off. Thus, the bonding board 20 is fabricated. Note that while only one bonding board 20 is shown in Fig. 2, a plurality may be formed on the glass substrate 10.

Next, in Step 5, an adhesive layer 21 formed of adhesive agent is transferred onto the face A of the bonding board (glass substrate 10) 20. At this time, no adhesive agent adheres to the portions of the excitation portion protecting hollow structure 16, the electroconductive pad through holes 18, and the alignment mark through hole 19. Forming the adhesive layer 21 on the bonding board 20 enables the danger of preventing adhesion of adhesive agent to the IDT and the like to be avoided.

Next, as shown in Fig. 3, in Step 6, the SAW device 6 fabricated in Step 1 and the bonding board 20 having the adhesive layer 21 fabricated in Steps 2 through 5 are bonded to each other. At this time, the alignment mark 5 of the SAW element 6 and the alignment mark through hole 19 of the bonding board 20 are matched in position. Thus, bonding is performed upon the electroconductive pads 3 of the SAW element 6 and the electroconductive pad through holes 18 of the bonding board 20 having been positioned. Also, the glass substrate and the LiTaO₃ piezoelectric substrate have a high degree of flatness, so temporary fixing at the time of bonding to each other is easy. Also, a transparent glass substrate is used, so positioning is easy. Note that while Fig. 3 illustrates only one set of the SAW element 6 and bonding board 20 being bonded to each other, a plurality is formed.

Next, in Step 7, the face B of the bonding board 20 is applied with a lift-off resist (not shown) having openings for predetermined wiring. At this time, opening are formed in the resist so that external terminals for connecting to the electroconductive pads 3 of the SAW element 6 can be formed on the electroconductive pad through holes 18 of the bonding board (glass substrate 10) 20. The wiring pattern may be formed such that the face B of the bonding board 20 has L component or C component, for example. Metal for multi-layered structure wiring, of Au (200 nm)/Pd (100 nm)/Ti (100 nm) for example, is vapor-deposited from above the lift-off resist, and the resist is lifted off. Thus, external terminal connection material 22a can be formed so as to connect the electroconductive pads 3 of the SAW element 6 to the bonding board 20. Also, the external terminal connection material 22a and the external electrodes 22b may be formed at the same time. Further, the formation of the external electrodes 22b may be before or after formation of the external terminal connection material 22a.

Next, in order to alleviate the shock of mounting, in Step 8, a shock-absorbing resin layer 23 for absorbing shock is formed on the entire face of the SAW element 6. Finally, dicing is performed at predetermined locations, thereby completing a SAW filter 51.

While the above-described method uses a glass substrate for the bonding board 20, the present invention is not restricted to this, and monocrystalline SiO₂ (quartz) substrates or fused silica substrates may be used, for example. According to these substrates, wet etching can be performed, so the through holes and the excitation portion protecting hollow structure and the like can be formed easily and inexpensively. Particularly, the bonding board 20 is preferably transparent to facilitate positioning. Also, a resin film formed of polyimide or the like may be used for the bonding board. That is to say, that is to say, the bonding board is an insulator, preferably with a relative permittivity lower than that of the piezoelectric substrate of the SAW element (the LiTaO₃ or LiNbO₃ serving as the piezoelectric substrate has a relative permittivity of 20 or greater, so a relative permittivity of 4 or smaller is preferable).

Also, the glass substrate 10 is preferably formed to a smaller size (small piece) than the piezoelectric substrate 1 beforehand. Thus, offset at the time of bonding, due to the difference in thermal expansion between the piezoelectric substrate of the SAW element and the glass substrate can be reduced. Division into individual SAW filters can be realized by dicing at the end.

Also, a metal film such as Ti for example may be formed on the face of the piezoelectric substrate 1 on which the IDT is not formed, as a shield to prevent effects from external electromagnetic waves.

The adhesive layer 21 is preferably formed of, for example, a thermal setting such as an epoxy, silicone, phenol, polyimide, polyurethane, or the like, a thermoplastic resin such as polyphenylene sulfide or the like, or ultraviolet setting resin or the like, so that the SAW element 6 and the bonding board 20 can be bonded by applying heat, ultraviolet rays, or the like. However, materials which generate corrosive gasses or the like are preferably avoided.

Also, the adhesive layer 21 may be formed of a resin layer of polyimide, novolac resin, photosensitive benzo-cyclo-butene (BCB), or the like, a metal layer of solder or the like, or a metal layer of Al, Ag, Au, or the like, and an adhesive layer of an epoxy, a silicone, a polyimide, or the like. At this time, forming the metal layer at the excitation portion protecting hollow structure 16 of the bonding board 20 as well allows effects of external electromagnetic waves to be prevented. Further, while the adhesive layer 21 is formed on the bonding board 20 side with the above-described method, this may be formed on the SAW element 6 side instead. Also, a configuration may be used wherein not only the adhesive layer 21, but also an unshown resin layer (insulating layer) is formed on the bonding board side 20, with the resin layer 21 provided upon the resin layer. Moreover, an arrangement may be made wherein the resin layer is formed on the SAW element 6 side instead of the bonding board 20 side, and further with the resin layer 21 provided upon the resin layer.

Also, for example, resin with electroconductivity or without may be used for the shock-absorbing resin layer 23. Of these, material with electroconductivity is preferably, an example being epoxy resin containing Ag particles. Thus, providing electroconductivity enables effects of external electromagnetic waves to be prevented.

Also, the method for forming the external terminal connection material 22a is not restricted to that of the above-described method. For example, electroconductive paste may be filled in the electroconductive pad through holes 18 of the bonding board 20, or printed with a sufficient thickens, and then baked, to form the external terminal connection material (via hole) 22a. With this method as Well, the external terminal connection material 22a and the external electrodes 22b may be formed at the same time.

Examples of the electroconductive paste include a resin Ag paste, solder paste, low-temperature-baking Sn paste and Zn paste. Also, wiring can be formed on the bonding board 20 at the same time, so the manufacturing steps can be simplified.

Also, the resin used for the adhesive layer 21 is inexpensive, so costs can be reduced.

Also, the external terminal connection material 22a, or both the external terminal connection material 22a and the external electrodes 22b, may be formed by vapor deposition of a metal onto the entire face of the face B of the bonding board 20, and then etching. Also, a multi-layered structure may be formed wherein a Ti or NiCr layer is formed as a coherence layer and then an Au or Ag layer is fomred for solder wettability. Also, a Pd layer or Ni layer may be formed as a dispersion preventing layer between the coherence layer and the Au or Ag layer.

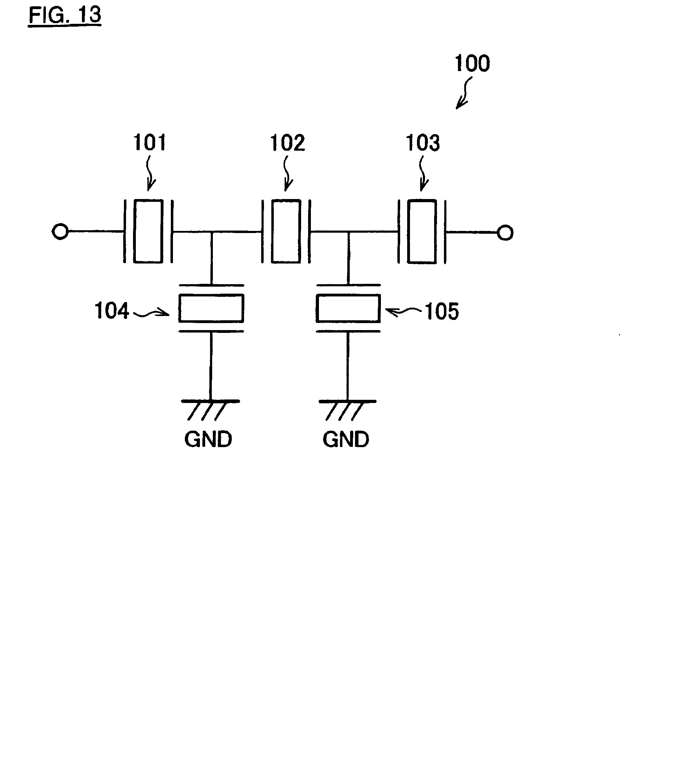

Further, a surface acoustic wave filter according to a more specific example of the embodiment of the present invention will be described with reference to Fig. 13 through Fig. 17. Now, with this specific example, a case wherein an upper resin layer (insulating layer) is provided in the SAW element side, and further, an adhesive layer is provided on the resin layer to perform bonding, will be described.

Fig. 13 illustrates a circuit diagram of a surface acoustic wave filter 100 according to the specific example. The surface acoustic wave filter 100 is of a configuration having surface acoustic wave resonators 101 through 105 having IDTs (vibrating portions) in a ladder form. Note that the surface acoustic wave resonators 101 through 103 are serial resonators, and the surface acoustic wave resonators 104 and 105 are parallel resonators.

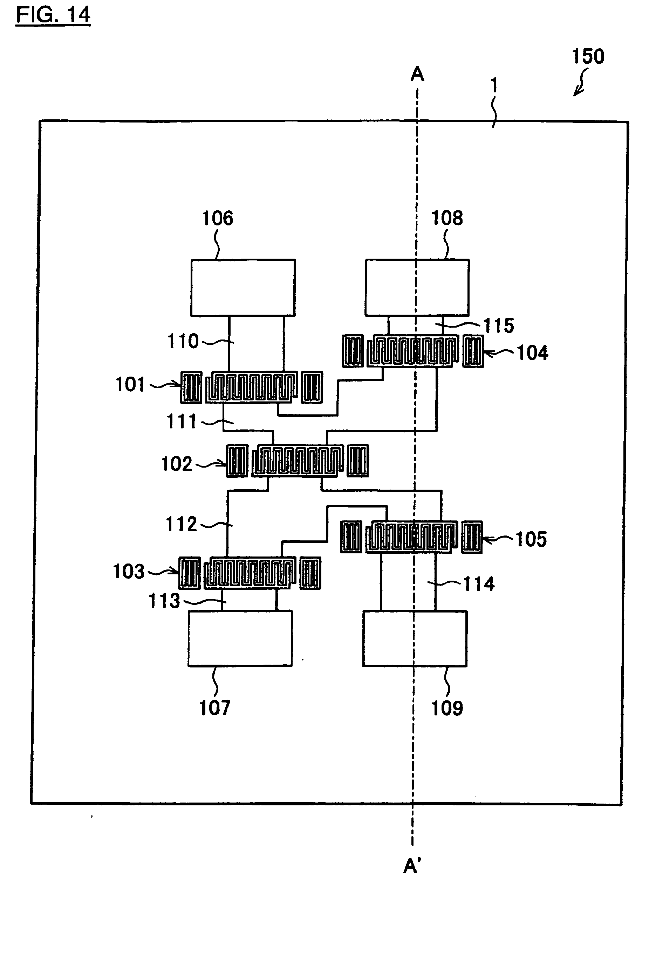

The following is a description of the method for forming the surface acoustic wave filter according to the present embodiment with reference to Fig. 14 through Fig. 17, with regard to the surface acoustic wave filter 100 according to the specific example.

First, as shown in Fig. 14, surface acoustic wave resonators 101 through 105, electroconductive pads (element wiring) 106 through 109, and lead wiring (element wiring) 110 through 115 are formed on a piezoelectric substrate 1, thereby fabricating a SAW element 150.

Note that the electroconductive pad 106 is connected to the input terminal, the electroconductive pad 107 to the output terminal, and the electroconductive pads 108 and 109 are both connected to ground terminals.

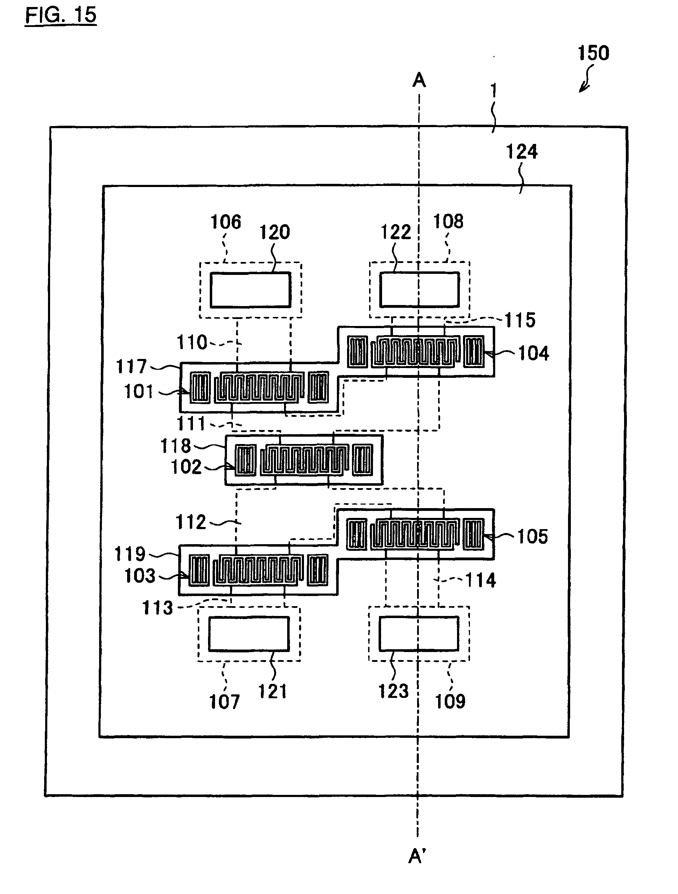

Next, as shown in Fig. 15, a resin layer 124 is formed on the SAW element 150, having resin layer openings 117 through 119 for exposing the surface acoustic wave resonators 101 through 105, and resin layer openings 120 through 123 where the electroconductive pads 106 through 109 are exposed. The resin layer 124 may cover the entire piezoelectric substrate 1. Also, an unshown adhesive layer is formed on the resin layer 124.

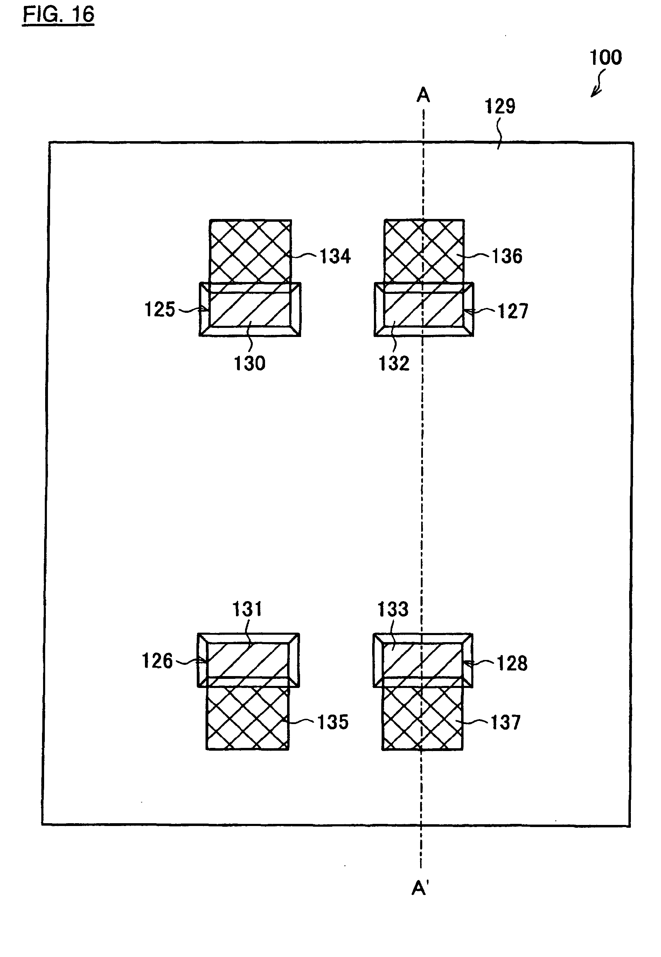

Next, as shown in Fig. 16, a bonding board 129 on which through holes 125 through 128 have been formed so that the electroconductive pads 106 through 109 are exposed is positioned and bonded onto the SAW element 150, thereby bonding the SAW element 150 and the bonding board 129. External terminal connecting material 130 through 133 connecting to the respective electrode pads 106 through 109, and external terminals 134 through 137 connected to the external terminal connecting material 130 through 133, are formed via the resin layer openings 120 through 123 and the through holes 125 through 128, thereby completing the surface acoustic wave filter 100.

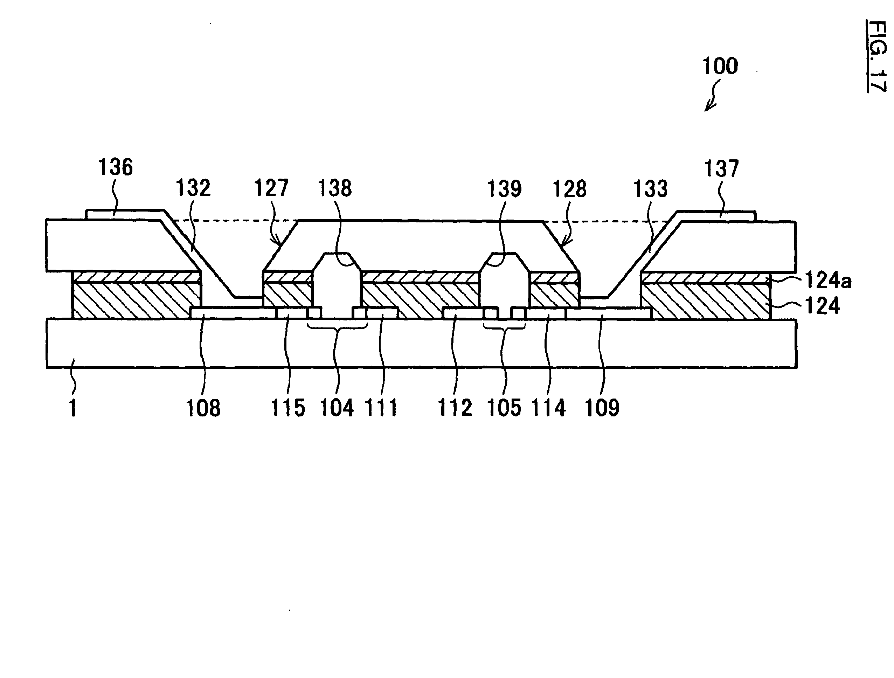

Now, a cross-sectional view along line A-A' shown in Fig. 14 through Fig. 16 of the completed surface acoustic wave filter 100 is shown in Fig. 17.

As shown in Fig. 17, an adhesive layer 124a is formed between the resin layer 124 and the bonding board 129 of the surface acoustic wave filter 100. Also, recesses 138 and 139 are provided at portions facing the surface acoustic wave resonators 104 and 105 of the SAW element 150. In the same way, recesses are also formed at portions of the bonding board 129 facing the surface acoustic wave resonators 101 through 103.

While protective space for the surface acoustic wave resonators having the IDTs (vibrating portions) is ensured by the resin layer, adhesive layer, and the recesses in the above, it is sufficient for the protective space to be ensured by at least one of the resin layer, adhesive layer, and recesses.

### [Second Embodiment]

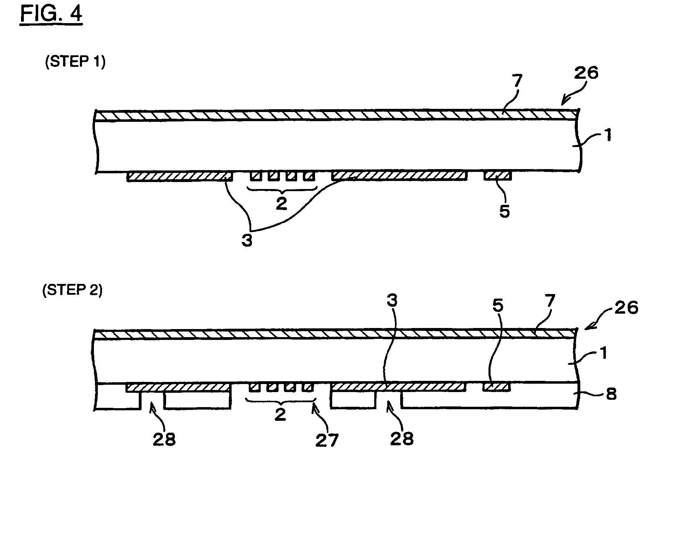

Another embodiment of the present invention will be described with reference to Fig. 4 through Fig. 6 and Fig. 18 through Fig. 22. Note that in order to facilitate description, members having the same functions as members illustrated in the above first embodiment will be denoted with the same reference numerals, and description thereof will be omitted.

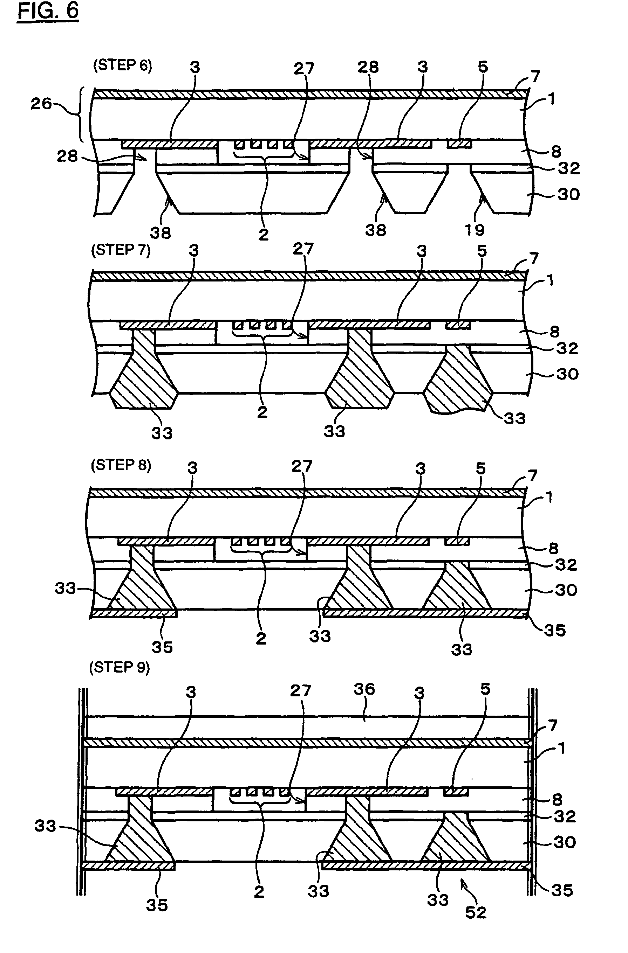

As shown in Fig. 6, with this embodiment, a SAW filter 52 wherein a SAW element 26 and a bonding board 30 are bonded together with an adhesive layer 32 will be described. With the present embodiment, the excitation portion protecting hollow structure in the first embodiment is not formed, and space for protecting the IDTs is ensured by the thickness of the resin layer 8.

The following is a detailed description of the method for manufacturing the above-described SAW filter, with reference to Fig. 4 through Fig. 6.

First, as shown in Fig. 4, in Step 1, the SAW element 26 is fabricated. The IDT 2, electroconductive pads 3, reflectors (not shown), and lead wiring (not shown), and the like, are formed on a LiTaO₃ piezoelectric substrate 1, which is 0.35 mm thick and 100 mm in diameter, for example. That is to say, the IDT 2, electroconductive pads 3, reflectors, and lead wiring, and the like, are formed of Al for example, on a LiTaO₃ piezoelectric substrate 1, by the lift-off method or the like using vapor deposition. A protective film 7 such as Ti or the like is formed on the face of the LiTaO₃ piezoelectric substrate 1 where the IDT 2 is not formed. Also, at the time of the lift-off using vapor deposition, alignment marks 5 are formed for positioning at the time of bonding to the later-described bonding board. Also, though only one SAW element 26 is illustrated in Fig. 4, this may be a group substrate wherein multiple SAW elements 26 are on the piezoelectric substrate 1.

Next, in Step 2, a photosensitive resin of an organic developing type such as photosensitive polyimide or the like, is applied onto the face of the LiTaO₃ piezoelectric substrate 1 where the IDT 2 is formed, and dried. This photosensitive resin is exposed according to a predetermined pattern, and developed, thereby forming a resin layer 8. At this time, an excitation portion protecting opening 27 for exposing the IDT 2 and reflectors and the like, and electroconductive pad openings 28 for exposing a part of the electroconductive pads 3 for external connection, are formed. The thickness of the resin layer 8 is to be a thickness wherein, when added to the thickness of the adhesive layer 32 on the bonding board 30 to be bonded to layer, the bonding board 30 does not come into contact with the IDT 2. This thickness is preferably around 20 µm, for example. Also, resin pools and resin stoppers can be formed at the same time as forming the excitation portion protecting opening 27. Further, the half-etching necessary for forming the excitation portion protecting hollow structure and the like in the later-described bonding board 30 is unnecessary, thereby enabling reduction in steps.

Thus, a SAW element 26 is fabricated.

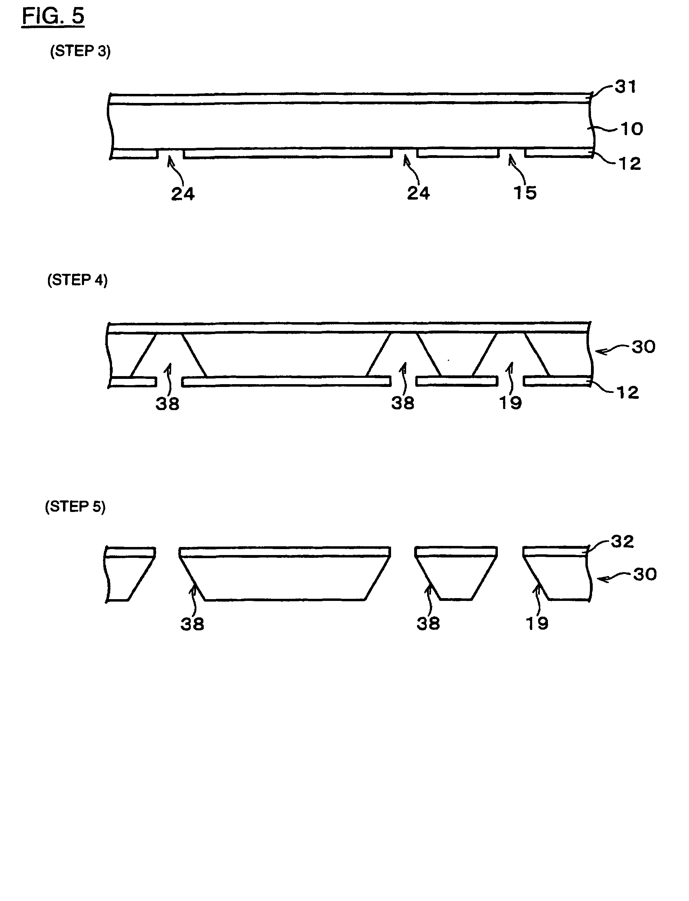

Next, as shown in Fig. 5, in Step 3 through Step 5, the bonding board 30 is fabricated in the same way as with the Steps 2, 4, and 5 in the first embodiment.

In Step 3, resist 31 is formed on the entirety of one face (the face facing the face of the LiTaO₃ piezoelectric substrate 1 on which the IDT 2 is formed (hereafter referred to as face A)) of a glass substrate 10 which is 0.20 mm thick and 100 mm in diameter, for example.

Further, a resist pattern 12 having electroconductive pad openings 24 matching the electroconductive pad openings 28 for conducting with the electroconductive pads 3, and an opening 15 for an alignment mark, is formed on the other face of the glass substrate 10 (hereafter referred to as face B).

Next, in Step 4, through etching is performed with hydrofluoric acid or the like on the face B of the glass substrate 10 following the resist pattern 12, thereby forming the electroconductive pad through holes 38 and alignment mark through hole 19. At this time, through etching is performed from one side, so electroconductive pad through holes 38 and alignment mark through hole 19 are formed in a tapered shape. Subsequently, the resist patterns 12 and 31 are peeled off. Thus, the bonding board 30 is fabricated. Note that while only one bonding board 30 is shown in Fig. 5, a plurality may be formed on the glass substrate 10.

Next, in Step 5, an adhesive layer 32 formed of adhesive agent is transferred onto the face A of the bonding board (glass substrate 10) 30. In this case, the resin layer 8 which is 20 µm thick has already been formed on the piezoelectric substrate side, so an adhesive agent can be formed on the entire face of the bonding board. At this time, no adhesive agent adheres to the portions of the electroconductive pad through holes 38 and the alignment mark through hole 19. While the adhesive layer 32 may be formed on the resin layer 26 of the SAW substrate 8, forming the adhesive layer 32 on the bonding board 30 enables adhesion of adhesive agent to the IDT 2 and the like to be prevented, and accordingly is more preferable.

Next, as shown in Fig. 6, in Step 6, the SAW device 26 fabricated in Step 1 and Step 2 and the bonding board 30 having the adhesive layer 32 fabricated in Steps 3 through 5 are bonded to each other. At this time, the alignment mark 5 of the SAW element 26 and the alignment mark through hole 19 of the bonding board 30 are matched. Thus, application is performed upon the electroconductive pads 3 of the SAW element 26 and the electroconductive pad opening 28 and the electroconductive pad through holes 38 of the bonding board 30 having been positioned. Also, the resin layer 8 has a sufficient thickness, so adhesion of the adhesive agent to the IDT 2 and electroconductive pads 3 and the like can be prevented.

Next, in Step 7, a resin Ag paste for example is printed and filled in the electroconductive pad through holes 38 and the alignment mark through hole 19, and baked thereby forming metal filled portions 33. The adhesive layer 32 can also be hardened at the same time. Also, in the event that a photosensitive resin is used for the resin layer 8 for example, this photosensitive resin can be hardened. Further, the unnecessary parts of the metal filled portions 33 can be removed by grinding, for example.

Next, in Step 8, a resin Ag paste, for example, is printed following a predetermined pattern, and baked, thereby forming external terminals 35 connecting to the metal filled portions (external terminal connecting material) 33. At the time of this printing, wiring may be formed on the bonding board 30 so as to have L component or C component. Also, the metal filled portions 33 and the external terminals 35 may be printed and formed at the same time.

Next, in order to alleviate the shock of mounting, in Step 9, a shock-absorbing resin layer 36 for absorbing shock is formed on the entire face of the protective film 7 formed on the SAW element 6. Finally, dicing is performed at predetermined locations, thereby completing a SAW filter 52.

As described above, with the completed SAW filter, the surface acoustic wave excitation portions (vibrating portions) such as the IDT 2 can be protected by the space formed by the excitation portion protecting opening 27 formed in the resin layer 8 and the adhesive layer 32.

Also, the external terminals 35 extend from the metal filled portions 33 of the bonding board, and can be changed to arbitrary positions according to the circuit or the like to be externally connected to, i.e., the degree of freedom regarding the position of the external terminals 35 can be improved.

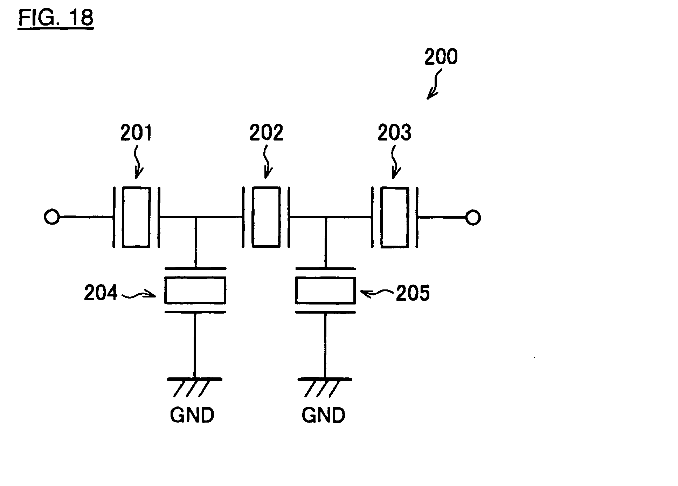

Further, a surface acoustic wave filter according to a more specific example of the embodiment of the present invention will be described with reference to Fig. 18 through Fig. 22.

Fig. 18 illustrates a circuit diagram of a surface acoustic wave filter 200 according to the specific example. The surface acoustic wave filter 200 is of a configuration having surface acoustic wave resonators 201 through 205 having IDTs (vibrating portions) in a ladder form. Note that the surface acoustic wave resonators 201 through 203 are serial resonators, and the surface acoustic wave resonators 204 and 205 are parallel resonators.

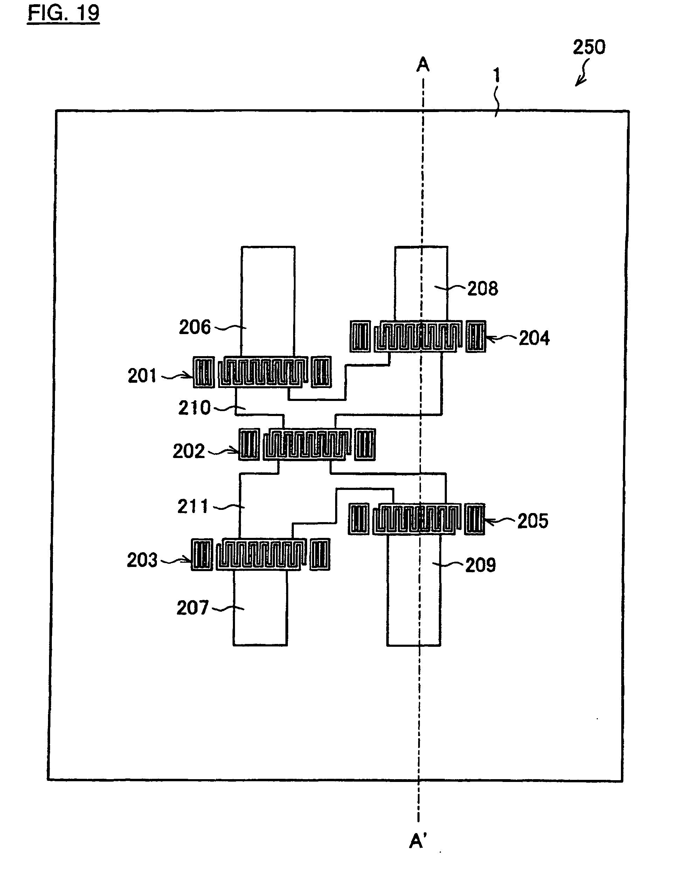

The following is a description of the method for forming the surface acoustic wave filter according to the present embodiment with reference to Fig. 19 through Fig. 21, with regard to the surface acoustic wave filter 200 according to the specific example.

First, as shown in Fig. 19, surface acoustic wave resonators 201 through 205 and lead wiring (element wiring) 206 through 211 are formed on a piezoelectric substrate 1, thereby fabricating a SAW element 250.

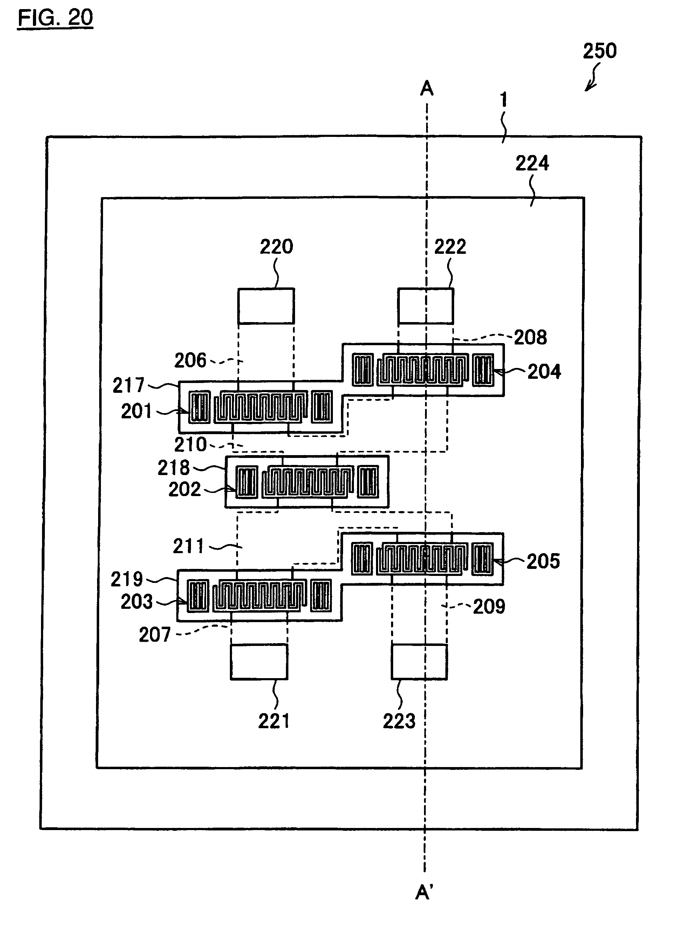

Next, as shown in Fig. 20, a resin layer 224 is formed on the SAW element 250, having resin layer openings 217 through 219 for exposing the surface acoustic wave resonators 201 through 205, and resin layer openings 220 through 223 where a part of the lead wiring 206 through 211 is exposed. The resin layer 224 may cover the entire piezoelectric substrate 1.

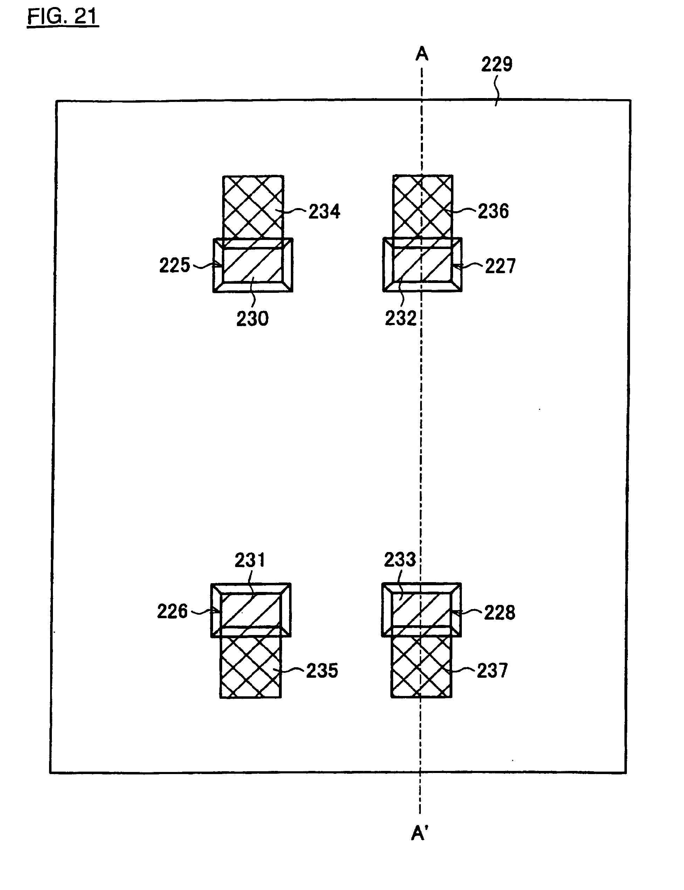

Next, as shown in Fig. 21, a bonding board 229 on which through holes 225 through 228 have been formed so that the lead wiring 206 through 209 is exposed is positioned and bonded onto the SAW element 250, thereby bonding the SAW element 250 and the bonding board 229. At this time, an unshown adhesive layer is formed on the bonding board 229. External terminal connecting material 230 through 233 connecting to the respective lead wiring 206 through 209, and external terminals 234 through 237 connected to the external terminal connecting material 230 through 233, are formed via the resin layer openings 220 through 223 and the through holes 225 through 228, thereby completing the surface acoustic wave filter 200.

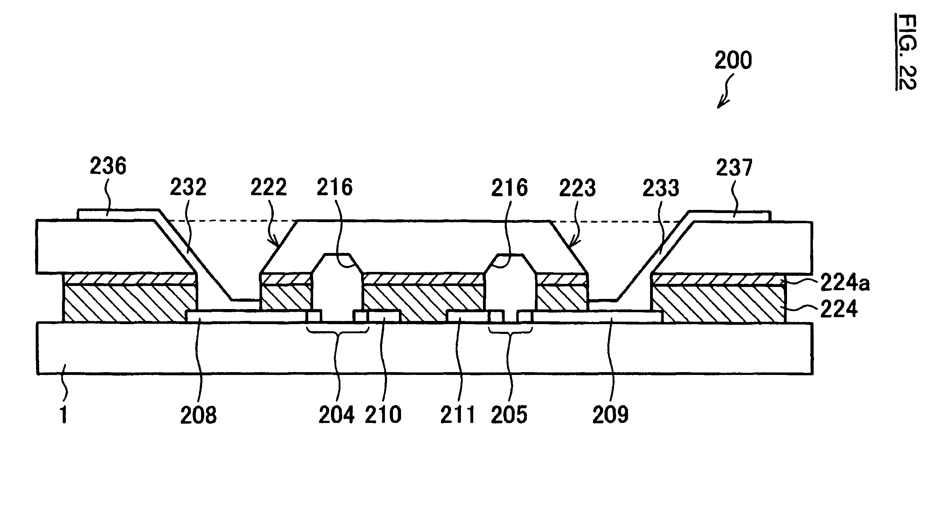

Now, a cross-sectional view along line A-A' shown in Fig. 19 through Fig. 21 of the completed surface acoustic wave filter 200 is shown in Fig. 22.

As shown in Fig. 22, an adhesive layer 224a is formed between the resin layer 224 and the bonding board 229 of the surface acoustic wave filter 200. Also, with regard to the surface acoustic wave resonators 204 and 205 of the SAW element 250, protective space for the IDTs of the surface acoustic wave resonators is ensured by the thickness of the resin layer 224. In the same way, with regard to the surface acoustic wave resonators 201 through 203 as well, protective space for the IDTs of the surface acoustic wave resonators is ensured by the thickness of the resin layer.

While protective space for the surface acoustic wave resonators having the IDTs (vibrating portions) is ensured by the resin layer, adhesive layer, and the recesses in the above, it is sufficient for the protective space to be ensured by at least one of the resin layer, adhesive layer, and recesses.

### [Third Embodiment]

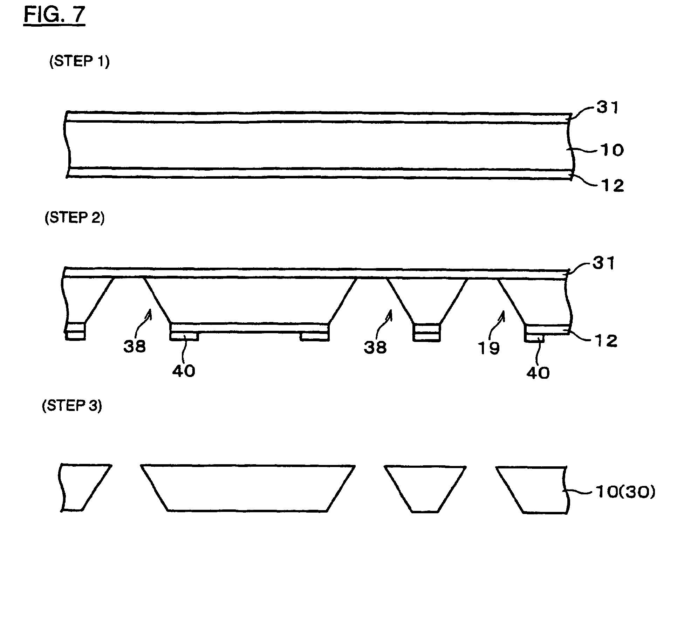

Yet another embodiment of the present invention will be described with reference to Fig. 7. Note that in order to facilitate description, members having the same functions as members illustrated in the above first and second embodiments will be denoted with the same reference numerals, and description thereof will be omitted.

With the present embodiment, the electroconductive pad through holes 38 and the alignment mark through hole 19 in the bonding board 20 in the above-described second embodiment are formed by laser.

That is to say, the bonding board 30 is fabricated by replacing Step 3 and Step 4 in the second embodiment with Step 1 through Step 3 shown in Fig. 7. That is, in Step 3 of the second embodiment, the resist pattern 12 is formed on the entire face without being formed with photolithography (Step 1). In Step 4, etching is performed by laser, thereby forming the electroconductive pad through holes 38 and the alignment mark through hole 19 (Step 2). Thus, the photolithography step can be omitted, and costs can be reduced. Also, the holes can be tapered by controlling the power of the laser. While fused matter called dross 40 adheres around the electroconductive pad through holes 38 and the alignment mark through hole 19 due to the laser, this can be readily removed along with the resist pattern 12 in Step 3, so there is no increase in steps. Note that the dross may be removed by lightly etching in the state in Step 2. Note that while only one bonding board 30 is shown in Fig. 7, a plurality may be formed on the glass substrate 10.

Subsequently, the SAW filter can be manufactured following Step 5 of the second embodiment.

In the event of etching with laser in this way, a sapphire (Al₂O₃ monocrystal) substrate, MgF substrate, MgO substrate, LiF substrate, CaF₂ substrate, BaF substrate, or the like, may be used instead of the glass substrate 10.

Also, instead of etching with laser, sandblasting processing may be performed to form the electroconductive pad through holes 38 and the alignment mark through hole 19.

### [Fourth Embodiment]

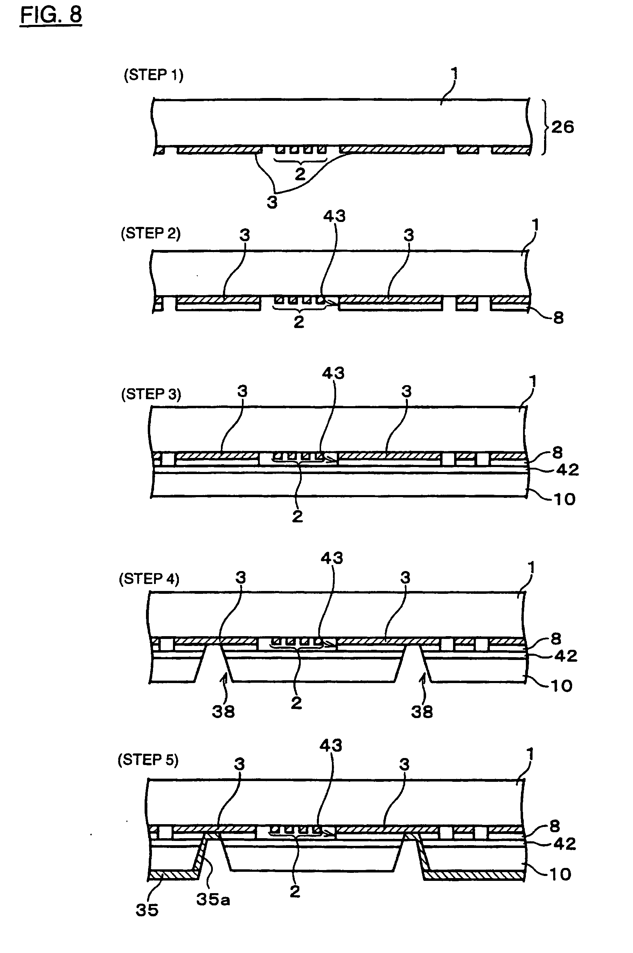

Another embodiment of the present invention will be described with reference to Fig. 8. Note that in order to facilitate description, members having the same functions as members illustrated in the above first through third embodiments will be denoted with the same reference numerals, and description thereof will be omitted.

With the present embodiment, as shown in Fig. 8, the electroconductive pad through holes 38 and the alignment mark through hole 19 in the bonding board 30 in the above-described second embodiment are formed by laser, following adhesion to the SAW element 26.

That is, in Step 1, as with Step 1 in the second embodiment, the SAW element 26 is fabricated wherein the IDT 2, electroconductive pads 3, reflectors (not shown), and lead wiring (not shown), and the like, are formed on a LiTaO₃ piezoelectric substrate 1. However, there is no need to form the alignment mark with the present embodiment. Also, though only one SAW element 26 is illustrated in Fig. 8, this may be a group substrate wherein multiple SAW elements 26 are on the piezoelectric substrate 1.

Next, in Step 2, as with Step 2 in the second embodiment, a resin layer 8 is formed on the SAW element 26. The resin layer 8 can be formed by applying a photosensitive resin of an organic developing type such as photosensitive polyimide or the like, dried, and then exposed and developed. At this time, a space (excitation portion protecting opening 43) for protecting the surface acoustic wave excitation portion such as the IDT 2 is to be secured. The thickness of this resin layer 8 is preferably around 20 µm, for example.

Next, in Step 3, the resin layer 8 of the SAW element 26, and the glass substrate 10 with an adhesive layer 42 formed on the entire face thereof, are bonded. There is no need here to position the glass substrate 10.

Next, in Step 4, the glass substrate 10 and the adhesive layer 42 are etched by laser, thereby forming the electroconductive pad through holes 38. This exposes the electroconductive pads 3.

While dross (not shown) is generated due to the laser etching at this time, this can be removed by half-etching with hydrofluoric acid, if necessary.

Next, in Step 5, as illustrated with the first embodiment, external terminal connecting material (extraction wiring) 35a to be connected with the electroconductive pads 3 via the electroconductive pad through holes 38 is formed, and external terminals 35 are formed so as to be in contact with the external terminal connecting material 35a.

Finally, dicing is performed at predetermined locations, thereby completing a SAW filter.

As described above, with the above method, positioning of the glass substrate 10 in Step 3 is unnecessary, making manufacturing easier.

### [Fifth Embodiment]

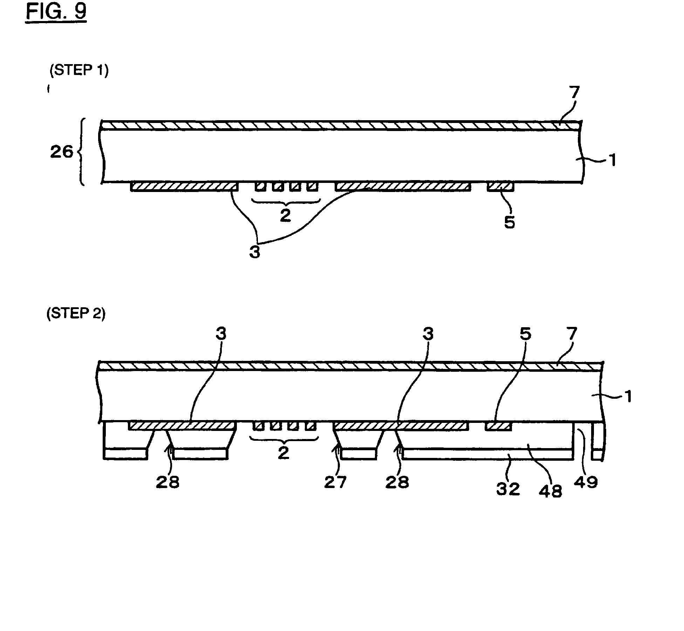

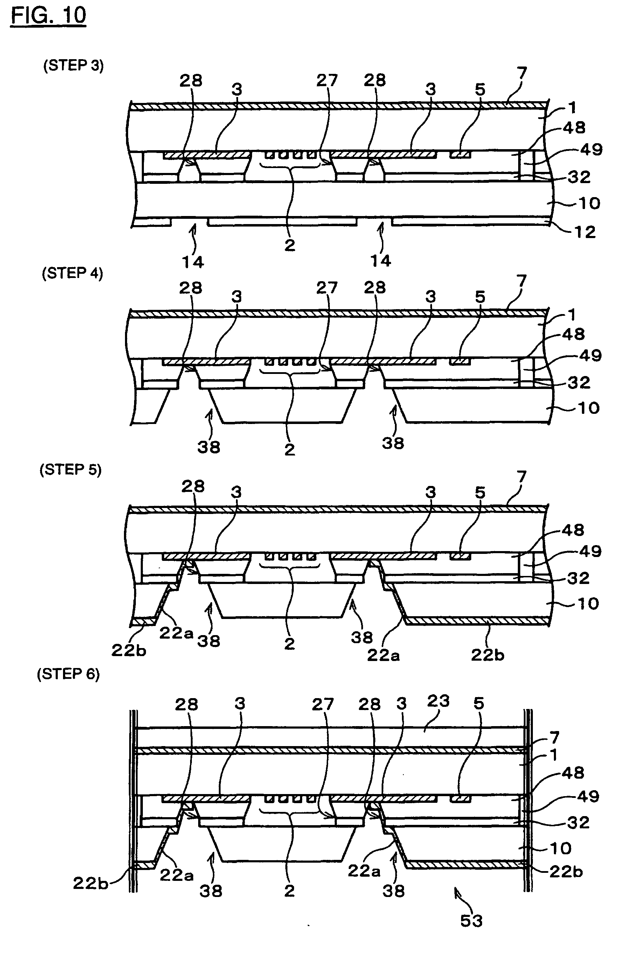

Another embodiment of the present invention will be described with reference to Fig. 9 and Fig. 10. Note that in order to facilitate description, members having the same functions as members illustrated in the above first through fourth embodiments will be denoted with the same reference numerals, and description thereof will be omitted.

The present embodiment is an example wherein, as shown in Fig. 10, the SAW element 26 in the second embodiment is provided with an adhesive layer 32 and bonded with the glass substrate 10, following which the electroconductive pad through holes 38 are formed in the glass substrate 10.

That is, as shown in Fig. 9, in Step 1, as with Step 1 of the first embodiment, a SAW element 26 having the IDT 2, electroconductive pads 3, reflectors (not shown), the alignment mark 5, lead wiring (not shown), and the like, formed of Al on a LiTaO₃ piezoelectric substrate 1 for example, is fabricated. Subsequently, Ti (20 nm) and Au (100 nm) for example, are deposited (not shown) on the electroconductive pads by the lift-off method. With the present embodiment, a protective film 7 of Ti or the like is formed on the LiTaO₃ piezoelectric substrate 1. Also, though only one SAW element 26 is illustrated in Fig. 9, this may be a group substrate wherein multiple SAW elements are on the piezoelectric substrate 1.

Next, in Step 2, a photosensitive resin such as photosensitive polyimide or the like is applied to a thickness of 15 µm for example, and dried. This photosensitive resin is further exposed and developed, thereby forming a resin layer 48 having an excitation portion protecting opening 27 for protecting the IDT 2 and reflectors and the like, electroconductive pad openings 28, and a dicing line opening 49. The exposing conditions are optimized at this time to make the openings tapered shapes. Forming the dicing line opening 49 as described above suppresses clogging at the time of dicing. Also, the dicing line opening 49 is preferably equal to the width of the dicing blade used for dicing. Thus, the protrusions of the glass does not damage as readily following dicing. Next, the adhesive layer 32 is transferred to the resin layer 48.

Next, as shown in Fig. 10, in Step 3, the glass substrate 10 is bonded to the adhesive layer 32, and the adhesive layer 32 is hardened. This bonding does not require positioning, since no patterns are formed on the glass substrate 10. This glass substrate 10 is a glass substrate 150 µm by 100 mm, for example. Further, a resist pattern 12 for forming through holes for exposing the electroconductive pads 3 is formed on the glass substrate 10. Openings 14 for exposing the electroconductive pads 3 are formed in the resist pattern 12. The openings 14 are formed larger than the electroconductive pad openings 28. Thus, formation of an overhanging shape between the through holes to be formed later and the electroconductive pad openings 28 (mushroom-shaped, i.e., a shape wherein the through hole portion on the glass substrate 10 side is smaller than the electroconductive pad openings 28) can be prevented. Accordingly, formation of the external terminals at a later time is facilitated. In the event of forming the external terminals by vapor deposition in particular, breakage of the external terminals can be prevented.

Next, in Step 4, the tapered electroconductive pad through holes 38 are formed by wet etching with hydrofluoric acid or the like. At this time, Au has been layered on the electroconductive pads 3, so corrosion due to the hydrofluoric acid can be prevented. Also, forming a Pt layer instead of Au can prevent corrosion by the hydrofluoric acid in the same say. Also, the protective film 7 also functions as a protective film regarding etching at the time of forming the electroconductive pad through holes 38 and the like.

Next, in Step 5, a negative photo-resist for example is applied on the glass substrate 10, dried, further exposed and developed, thereby forming a reverse-tapered resist pattern (not shown) for lift-off, having openings at the electroconductive pad through holes 38 and external terminal formation portions. In this way, a negative photo-resist is used, so there is no resist residue at the electroconductive pad through holes 38, and further, reverse-tapered shapes can be formed. Then, vapor deposition of Au (100 nm)/Ti (20 nm)/Ni (500 nm)/Ti (20 nm), for example, is performed in that order, so as to form external terminal connection material 22a and external terminals 22b at the same time, and the resist pattern is removed.

Next, in Step 6, in order to alleviate the shock of mounting, a shock-absorbing resin layer 23 for absorbing shock is formed on the entire face of the metal protective film 7 formed on the LiTaO₃ piezoelectric substrate 1. Finally, dicing is performed at predetermined locations, thereby completing a SAW filter 53.

### [Sixth Embodiment]

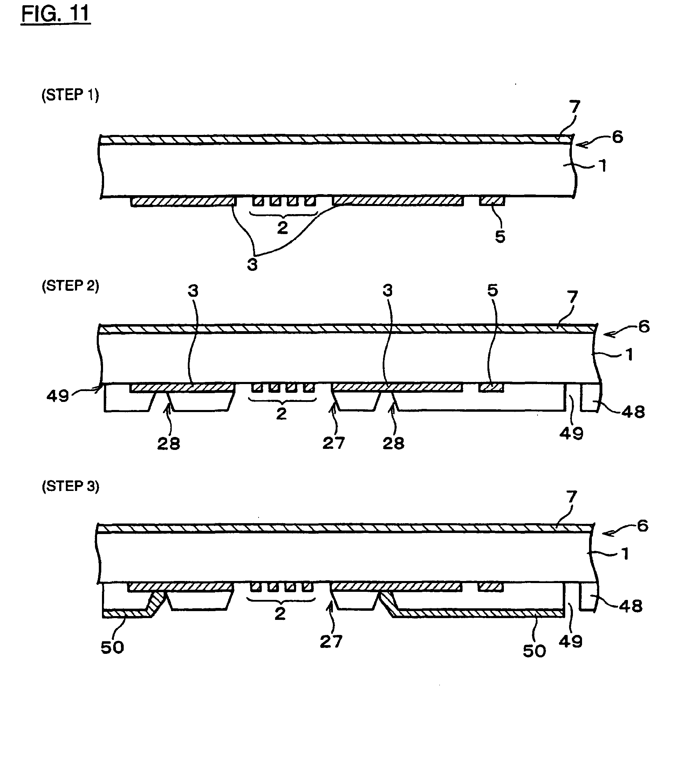

Another embodiment of the present invention will be described with reference to Fig. 11 and Fig. 12, and Fig. 23 through Fig. 34. Note that in order to facilitate description, members having the same functions as members illustrated in the above first through fifth embodiments will be denoted with the same reference numerals, and description thereof will be omitted.

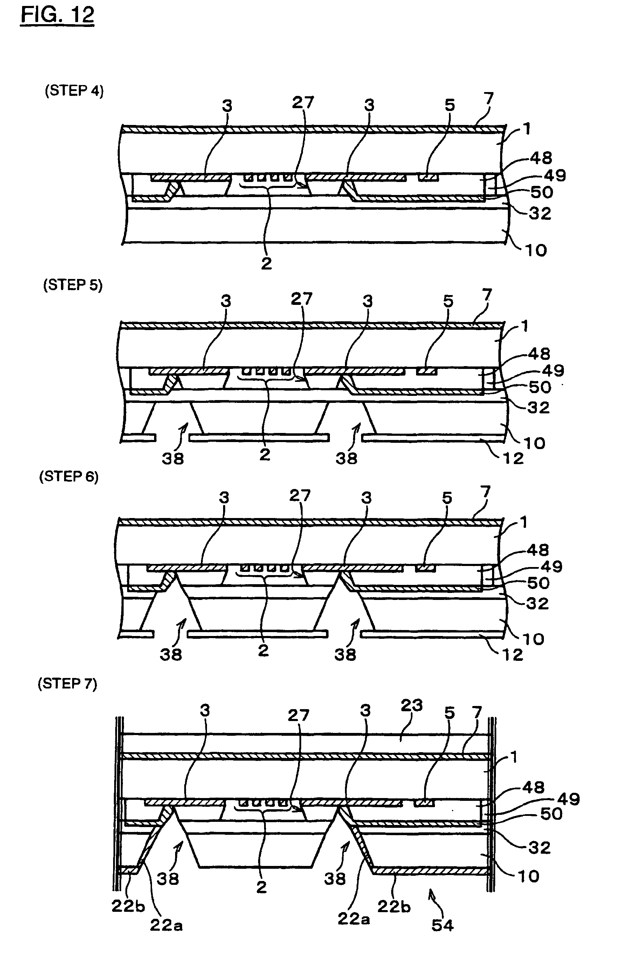

The present embodiment is an example wherein, as shown in Fig. 12, first wiring (extraction wiring) 50 is formed on the resin layer 48 in the fifth embodiment.

That is, as shown in Fig. 11, in Step 1, as with Step 1 of the fifth embodiment, a SAW element 6 having the IDT 2, electroconductive pads 3, reflectors (not shown), the alignment mark 5, wiring (not shown), and the like, formed of Al on a LiTaO₃ piezoelectric substrate 1 for example, is fabricated. Subsequently, Ti (20 nm) and Au (100 nm) for example, are deposited (not shown) on the electroconductive pads 3 by the lift-off method. With the present embodiment, a protective film 7 of Ti or the like is formed on the LiTaO₃ piezoelectric substrate 1. Also, though only one SAW element 6 is illustrated in Fig. 11, this may be a group substrate wherein multiple SAW elements 6 are on the piezoelectric substrate 1.

Next, in Step 2, a photosensitive resin such as photosensitive polyimide or the like is applied to a thickness of 15 µm for example, and dried. This photosensitive resin is further exposed and developed, thereby forming a resin layer 48 having an excitation portion protecting opening 27 for protecting the IDT 2 and reflectors and the like, electroconductive pad openings 28, and a dicing line opening 49. The exposing conditions are optimized at this time to make the openings tapered shapes. Forming the dicing line opening 49 as described above suppresses clogging at the time of dicing. Also, the dicing line opening 49 is preferably equal to the width of the dicing blade used for dicing. Thus, the protrusions of the glass does not damage as readily following dicing.

Next, in Step 3, first wiring 50 connected to the electroconductive pads 3 is formed on the resin layer 48 by the lift-off method, in the same way as with the electroconductive pads. The first wiring 50 may be used to include L component or C component. Also, the connection portion with the electroconductive pads 3 is extended by the first wiring 50. Thus, the through holes to be formed later should be formed only so that the first wiring 50 is exposed, thereby enabling the external terminals to be freely positioned.

Next, as shown in Fig. 12, in Step 4, the adhesive layer 32 is formed on the glass substrate 10, bonded to the SAW element 6, and hardened. This bonding does not require positioning, since no patterns are formed on the glass substrate 10. This glass substrate 10 is a glass substrate 150 µm by 100 mm, for example.

Further, in Step 5, a resist pattern 12 for forming through holes for exposing the first wiring 50 is formed on the glass substrate 10. Openings for exposing the first wiring 50 are formed in the resist pattern 12. Next, the tapered electroconductive pad through holes 38 are formed by wet etching with hydrofluoric acid or the like. The adhesive layer 32 is formed on the entire face of the glass substrate 10, so the adhesive layer 32 is not etched but remains.

Next, in Step 6, the adhesive layer 32 is etched with fuming nitric acid, an organic solvent, or the like. At this time, Au has been layered on the electroconductive pads 3 and the first wiring 50, so corrosion due to the hydrofluoric acid can be prevented. Also, forming a Pt layer instead of Au can prevent corrosion by the hydrofluoric acid in the same say. Also, the protective film 7 also functions as a protective film regarding etching at the time of forming the electroconductive pad through holes 38 and the like.

Also, laser etching or sandblasting processing may be performed instead of the Steps 5 and 6. In the event of etching with laser, the entire face of the glass substrate 10 is coated with resist, and then etched with laser. This does away with the need to form a resist pattern, and further, etching of the adhesive layer 32 can be performed at the same time. Hydrofluoric acid processing is then performed. This hydrofluoric acid processing is for removing fused material called dross.

Next, in Step 7, external terminal connection material 22a and external terminals 22b can be formed by printing Au-Sn solder, for example, through the electroconductive pad through holes 38, and treating with heat. Next, in order to alleviate the shock of mounting, a shock-absorbing resin layer 23 for absorbing shock is formed on the entire face of the metal protective film 7 formed on the LiTaO₃ piezoelectric substrate 1. Finally, dicing is performed at predetermined locations, thereby completing a SAW filter 54.

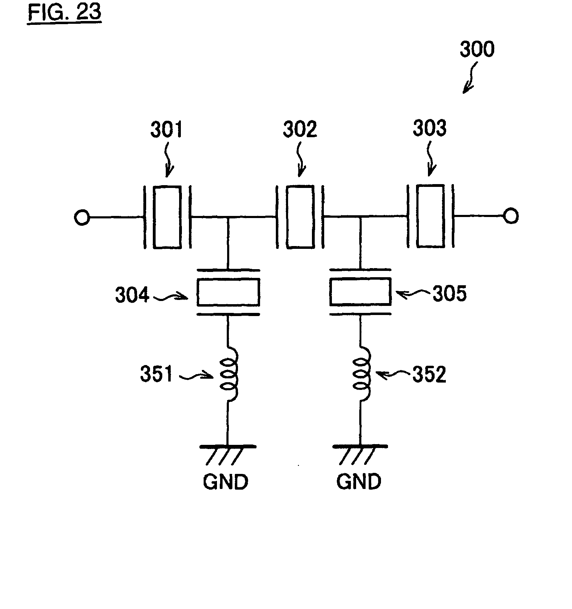

Further, a surface acoustic wave filter according to a more specific example of the embodiment of the present invention will be described with reference to Fig. 23 through Fig. 28.

Fig. 23 illustrates a circuit diagram of a surface acoustic wave filter 300 according to the specific example. The surface acoustic wave filter 300 is of a configuration having surface acoustic wave resonators 301 through 305 having IDTs (vibrating portions) in a ladder form. Note that the surface acoustic wave resonators 301 through 303 are serial resonators, and the surface acoustic wave resonators 304 and 305 are parallel resonators, with inductors 351 and 352 being serially connected to the surface acoustic wave resonators 304 and 305.

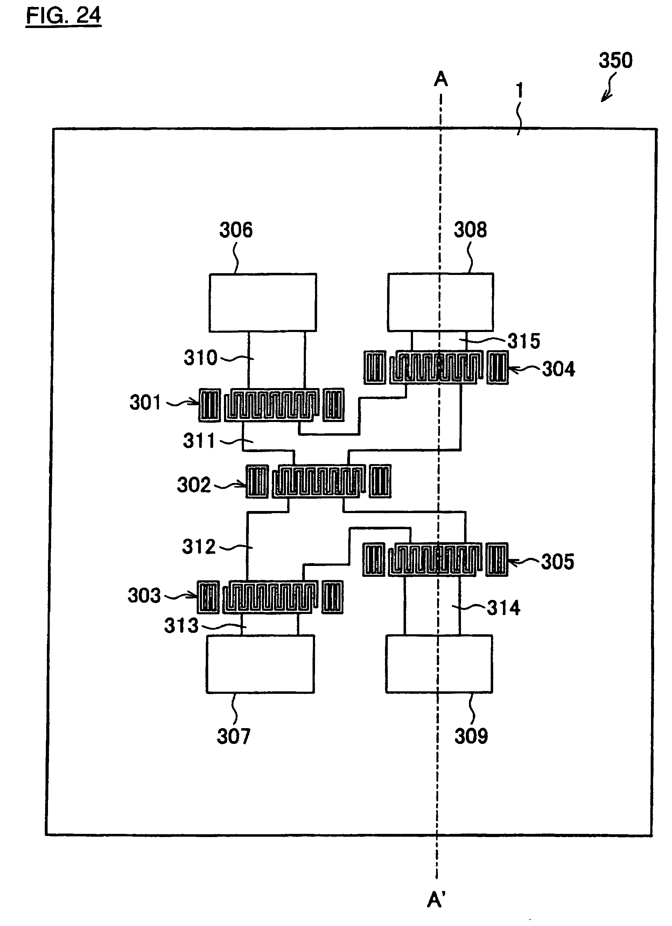

The following is a description with reference to Fig. 24 through Fig. 28, with regard to the surface acoustic wave filter 300 according to the above-described specific example.

First, as shown in Fig. 24, surface acoustic wave resonators 301 through 305, electroconductive pads (element wiring) 306 through 309, and lead wiring (element wiring) 310 through 315, are formed on a piezoelectric substrate 1, thereby fabricating a SAW element 350.

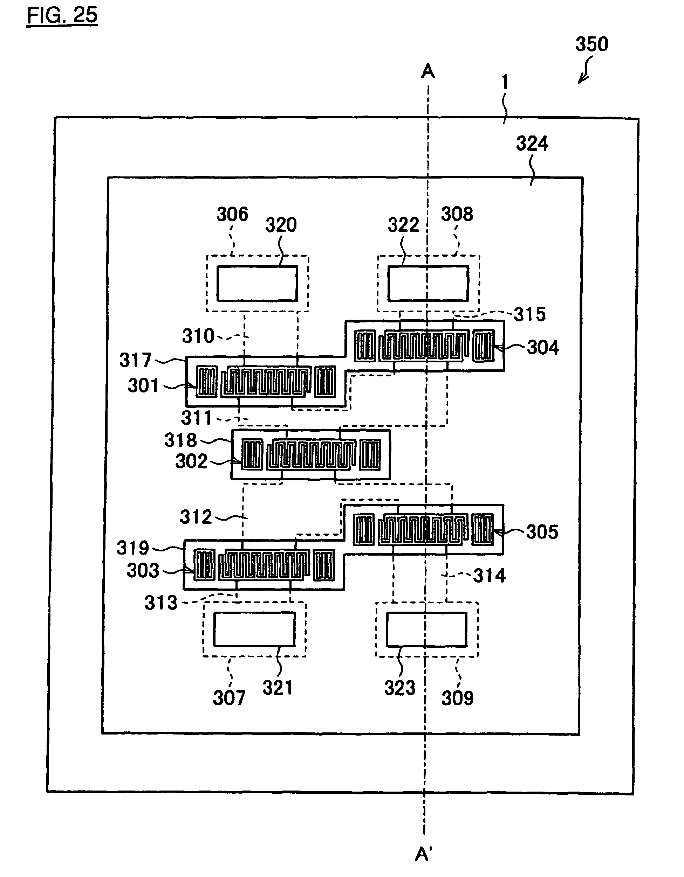

Next, as shown in Fig. 25, a resin layer 324 is formed on the SAW element 350, having resin layer openings 317 through 319 for exposing the surface acoustic wave resonators 301 through 305, and resin layer openings 320 through 323 where the electroconductive pads 306 through 309 are exposed. The resin layer 324 may cover the entire piezoelectric substrate 1.

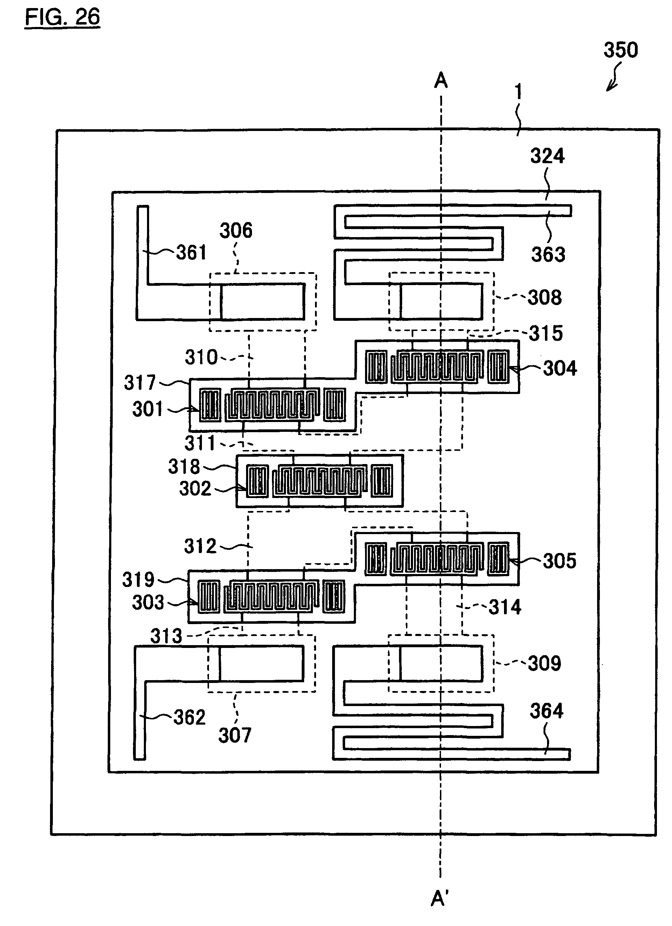

Next, as shown in Fig. 26, first wiring 361 through 364, connected to the electroconductive pads 306 through 309 via the resin openings 320 through 323, is formed. Note that the first wiring 363 and 364 is formed with inductors L. The inductors L on the first wiring 363 and 364 corresponds to the above inductors 351 and 352. While the first wiring has inductors L in the above description, electrodes may be formed in toothcomb shapes to provide the first wiring with capacitance C.

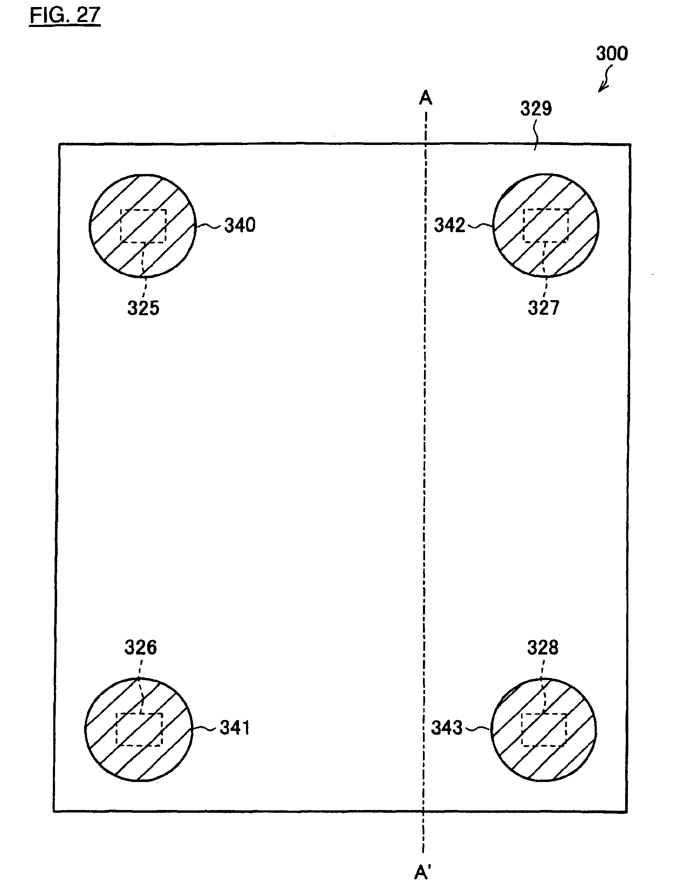

Next, as shown in Fig. 27, the bonding board 329 in which through holes 325 through 328 have been formed is positioned and bonded onto the resin layer 324 so that the ends of the first wiring 361 through 364 are exposed, and the SAW element 350 and the bonding board 329 are bonded by an unshown adhesive layer. External terminals 340 through 343 are then formed so as to be connected to the electroconductive pads 306 through 309 via the through holes 325 through 328, thereby completing the surface acoustic wave filter 300. The portions of the external terminals 340 through 343 which are formed at the through holes 325 through 328 can be considered to be external terminal connecting material. That is to say, the external terminals 340 through 343 are of a configuration wherein the external terminal connecting material and the external terminals are integrally formed.

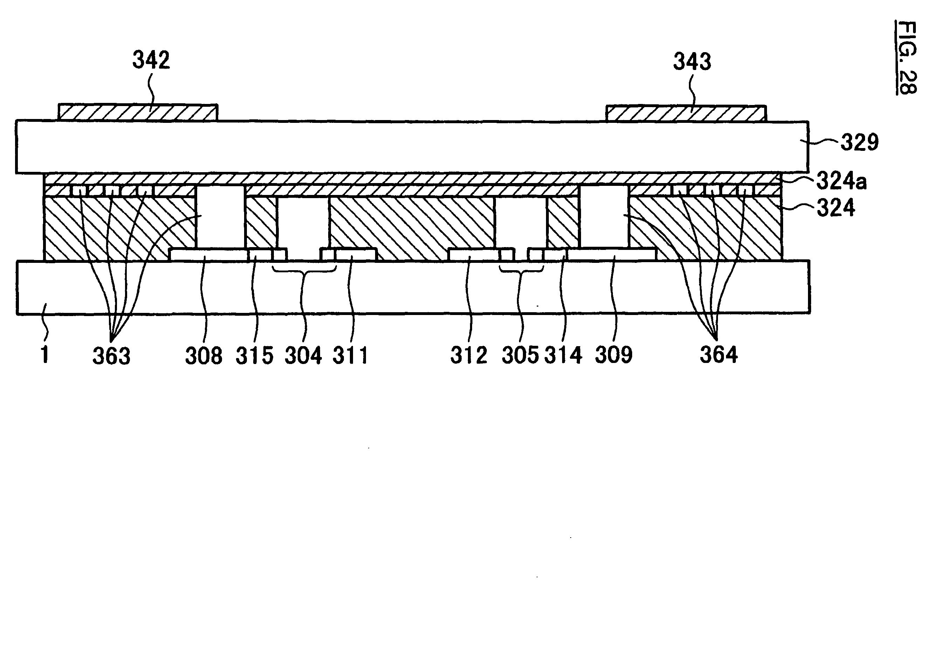

Now, a cross-sectional view along line A-A' shown in Fig. 24 through Fig. 27 of the completed surface acoustic wave filter 300 is shown in Fig. 28.

As shown in Fig. 28, an adhesive layer 324a is formed between the resin layer 324 and the bonding board 329 of the surface acoustic wave filter 300. Also, with regard to the surface acoustic wave resonators 304 and 305 of the SAW element 350, protective space for the IDTs of the surface acoustic wave resonators is ensured by the thickness of the resin layer 324. In the same way, with regard to the surface acoustic wave resonators 301 through 303 as well, protective space for the IDTs of the surface acoustic wave resonators is ensured by the thickness of the resin layer.

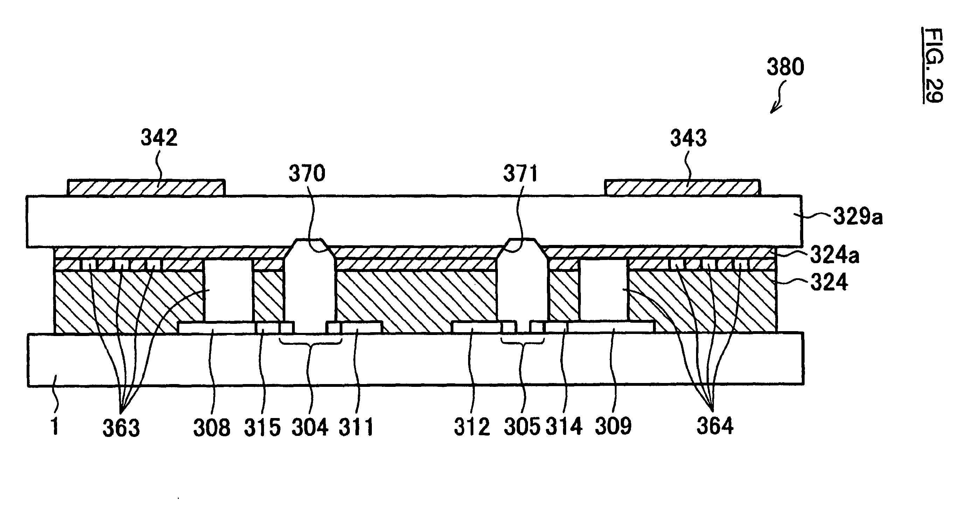

Further, a surface acoustic wave filter 380, which is a modification of the above-described surface acoustic wave filter 300, will be described with reference to Fig. 29. This surface acoustic wave filter 380 is an arrangement wherein recesses 370 and 371 are provided at portions facing the surface acoustic wave resonators 304 and 305 on the bonding board 329 of the surface acoustic wave filter 300. Moreover, recesses are also provided at portions facing the other surface acoustic wave resonators on the bonding board 329 as well.

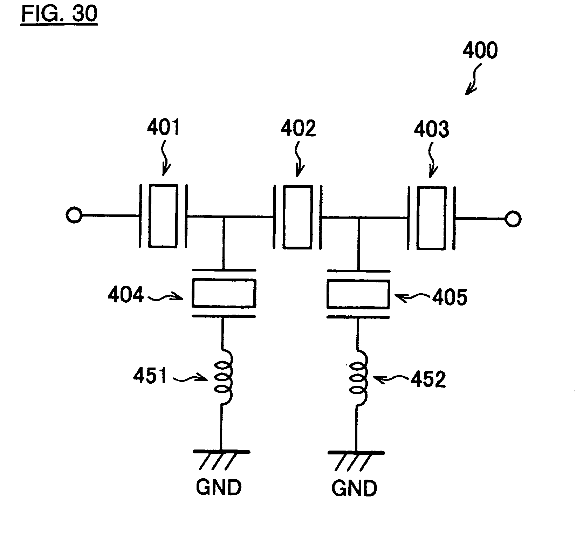

Further, a surface acoustic wave filter according to yet another specific example of the embodiment of the present invention will be described with reference to Fig. 30 through Fig. 34.

Fig. 30 illustrates a circuit diagram of a surface acoustic wave filter 400 according to the above-described specific example. The surface acoustic wave filter 400 is of a configuration having surface acoustic wave resonators 401 through 405 having IDTs (vibrating portions) in a ladder form. Note that the surface acoustic wave resonators 401 through 403 are serial resonators, and the surface acoustic wave resonators 404 and 405 are parallel resonators, with inductors 451 and 452 being serially connected to the surface acoustic wave resonators 404 and 405.

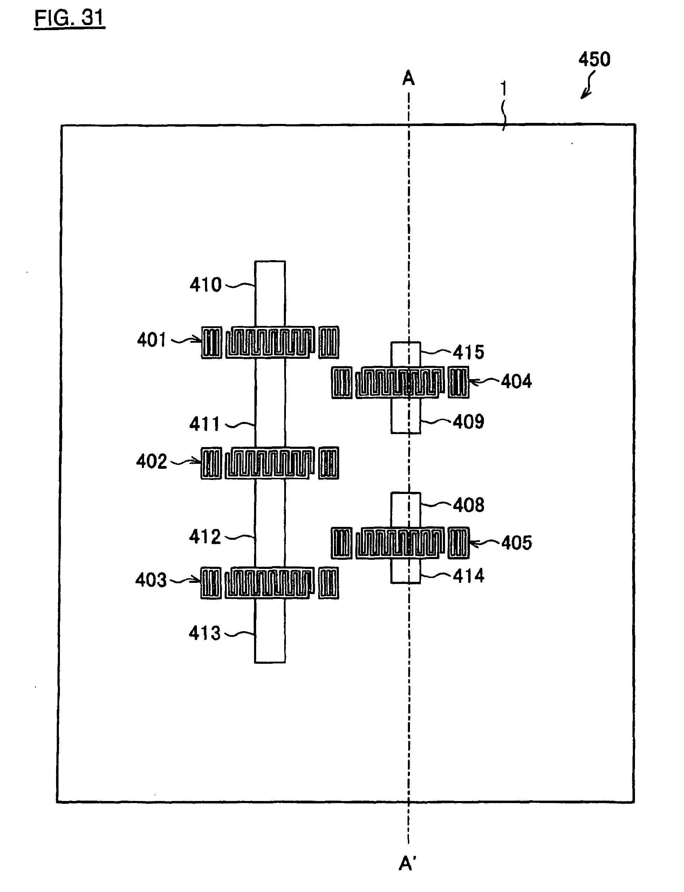

The following is a description with reference to Fig. 31 through Fig. 34, with regard to the surface acoustic wave filter 400 according to the above-described specific example.

First, as shown in Fig. 31, surface acoustic wave resonators 401 through 405 and lead wiring (element wiring) 408 through 415 are formed on a piezoelectric substrate 1, thereby fabricating a SAW element 450.

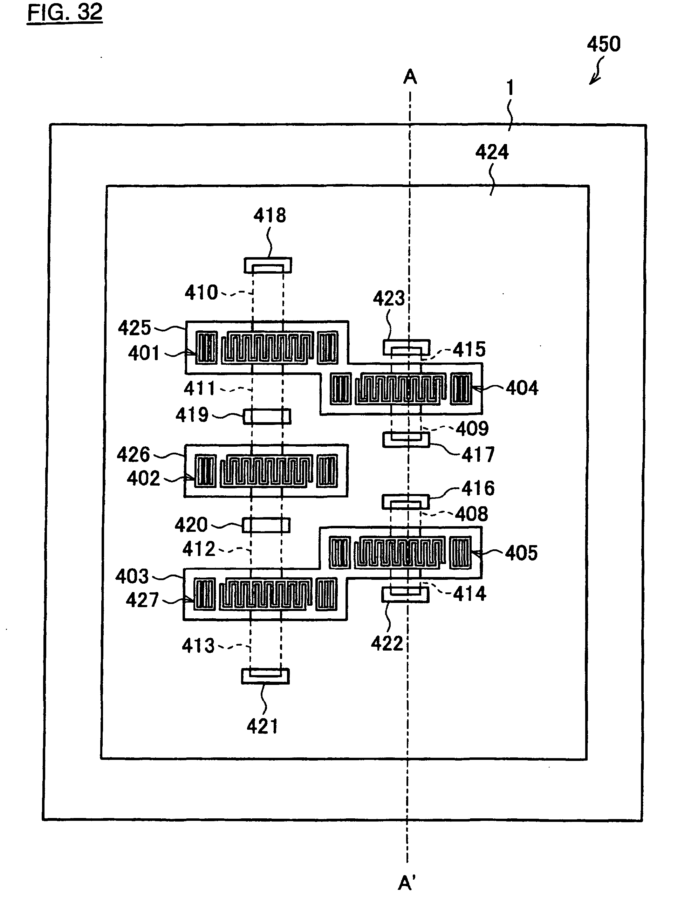

Next, as shown in Fig. 32, a resin layer 424 is formed on the SAW element 450, having resin layer openings 416 through 423 for exposing a part of the lead wiring 408 through 415, and resin layer openings 425 through 427 for exposing the surface acoustic wave resonators 401 through 405. The resin layer 424 may also cover the entire piezoelectric substrate 1.

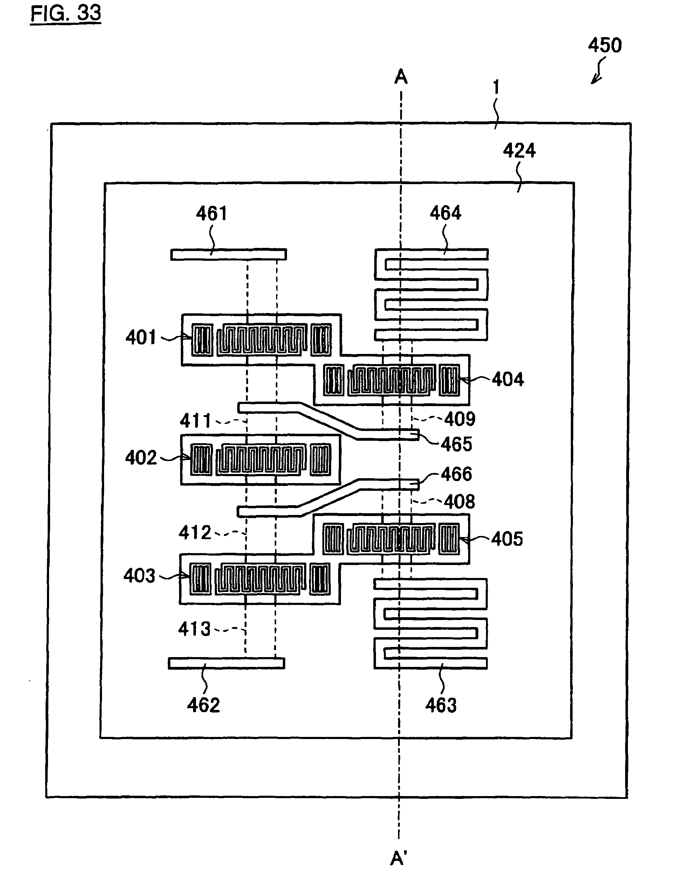

Next, as shown in Fig. 33, first wiring 461 through 464, connected to the lead wiring 410, 413, 414, and 415 via the resin openings 418, 421, 422, and 423, is formed. Note that the first wiring 463 and 434 is formed integrally with inductors L. The inductors L on the first wiring 463 and 464 corresponds to the above inductors 451 and 452. While the first wiring has inductors L in the above description, the first wiring may have capacitance C as well. Further, first wiring 465, connected to the lead wiring 409 and 411 via the resin openings 417 and 419, and first wiring 466, connected to the lead wiring 408 and 412 via the resin openings 416 and 420, is formed. Also, in some cases, the lead wiring 408 through 415 may be formed wider, or a part of the bus bar for the surface acoustic wave resonators 401 through 405 may be formed wiring, thereby allowing the connection between the lead wiring 408 through 415, the bus bar, and the first wiring 461 through 466, to be improved.

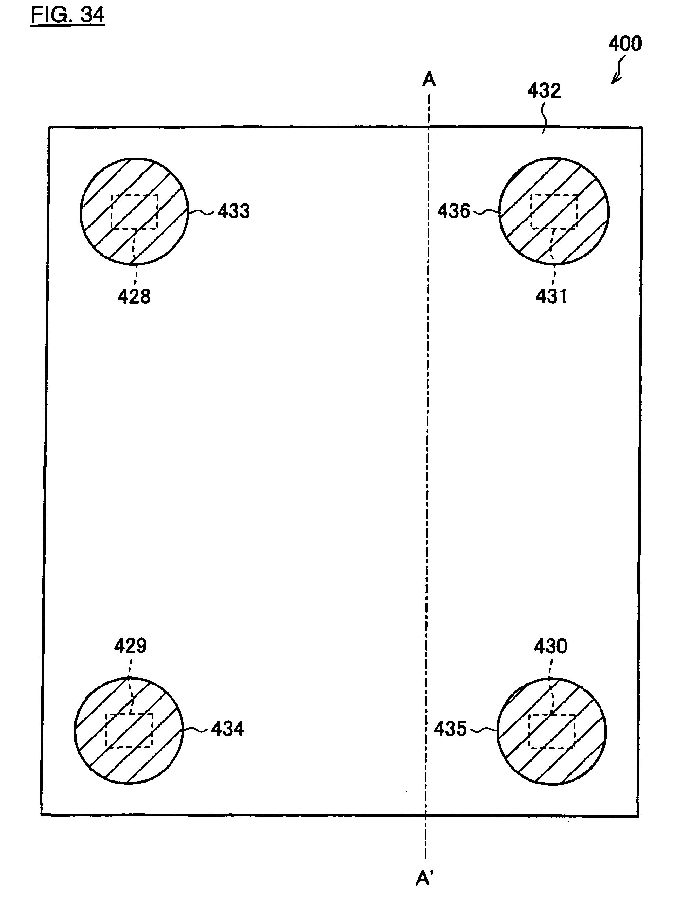

Next, as shown in Fig. 34, a bonding board 432 in which through holes 428 through 431 have been formed is positioned and bonded onto the resin layer 424 so that the ends of the first wiring 461 through 464 are exposed, and the resin layer 424 and the bonding board 432 are bonded by an unshown adhesive layer. External terminals 433 through 436 are then formed so as to be connected to the first wiring 461 through 464 via the through holes 428 through 431, thereby completing the surface acoustic wave filter 400. The portions of the external terminals 433 through 436 which are formed at the through holes 428 through 431 can be considered to be external terminal connecting material. That is to say, the external terminals 433 through 436 are of a configuration wherein the external terminal connecting material and the external terminals are integrally formed. The external terminal connecting material and the external terminals 433 through 436 may be formed by filling the through holes 428 through 431 with Au-Sn solder using a printing technique, for example, and treating with heat. Also, the external terminals may be thin films formed by lift-off. Also, the external terminal connecting material and the external terminals may be separated and formed with different methods.

With regard to the surface acoustic wave resonators 404 and 405 of the SAW element 450 in the surface acoustic wave filter 400, protective space for the IDTs of the surface acoustic wave resonators is ensured by the thickness of the resin layer 424. In the same way, with regard to the surface acoustic wave resonators 401 through 403 as well, protective space for the IDTs of the surface acoustic wave resonators is ensured by the thickness of the resin layer. Also, the protective space may be ensured by providing recesses at the portions of the bonding board 432 facing the surface acoustic wave resonators 401 through 405.

### [Seventh Embodiment]

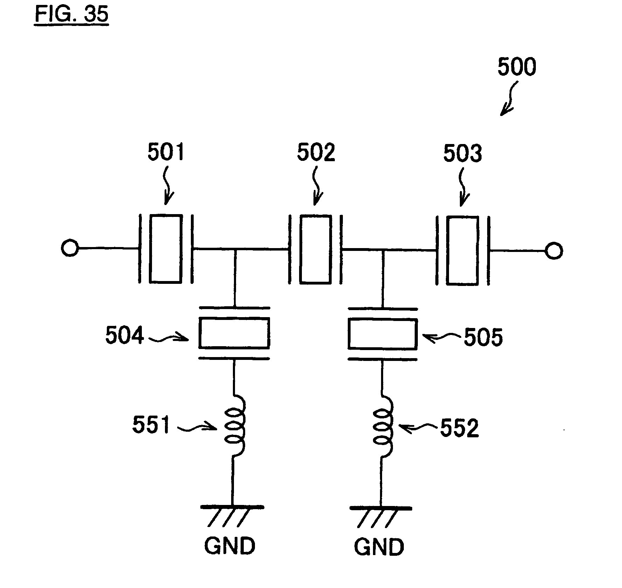

Another embodiment of the present invention will be described with reference to Fig. 35 through Fig. 48. Note that in order to facilitate description, members having the same functions as members illustrated in the above first through sixth embodiments will be denoted with the same reference numerals, and description thereof will be omitted.

A surface acoustic wave filter according to the present embodiment will be described with reference to Fig. 35 through Fig. 48.

Fig. 35 illustrates a circuit diagram of a surface acoustic wave filter 500 according to the present embodiment. The surface acoustic wave filter 500 is of a configuration having surface acoustic wave resonators 501 through 505 having IDTs (vibrating portions) in a ladder form. Note that the surface acoustic wave resonators 501 through 503 are serial resonators, and the surface acoustic wave resonators 504 and 505 are parallel resonators, with inductors 551 and 552 being serially connected to the surface acoustic wave resonators 504 and 505.

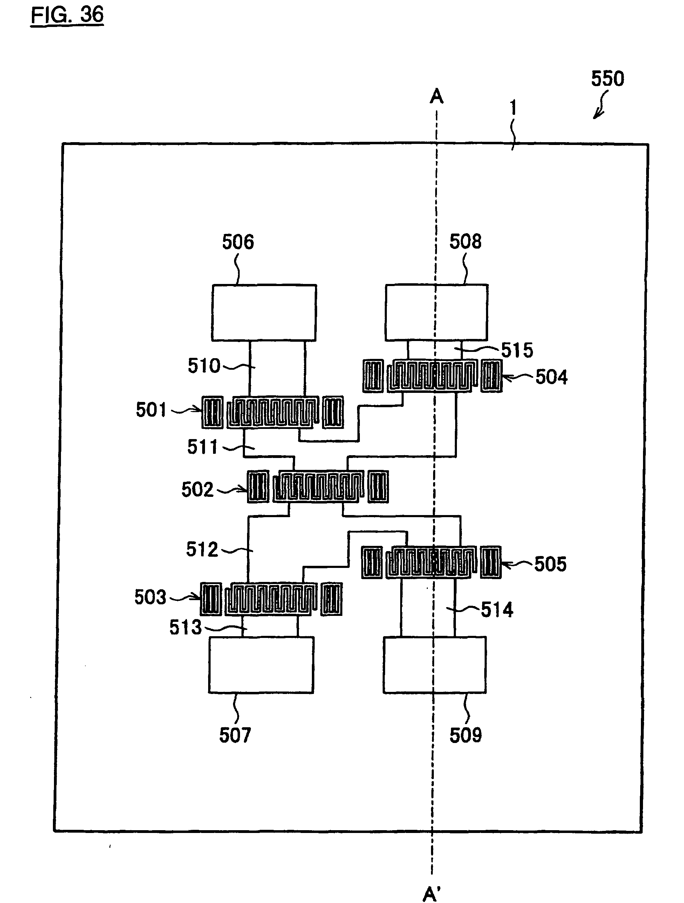

First, as shown in Fig. 36, surface acoustic wave resonators 501 through 505, electroconductive pads (element wiring) 506 through 509, and lead wiring (element wiring) 510 through 515, are formed on a piezoelectric substrate 1, thereby fabricating a SAW element 550.

With the present embodiment, a piezoelectric substrate of LiTaO₃, 0.35 mm thick, for example, can be used for the piezoelectric substrate 1. Also, the surface acoustic wave resonators 501 through 505 are formed of toothcomb electrodes and reflectors of a metal such as Al. Further, the electroconductive pads (element wiring) 506 through 509 and lead wiring (element wiring) 510 through 515 are also formed of a metal such as Al. The surface acoustic wave resonators 501 through 505, electroconductive pads (element wiring) 506 through 509, and lead wiring (element wiring) 510 through 515, can be formed by the lift-off method by vapor deposition. Also, multiple combinations of the surface acoustic wave resonators 501 through 505, electroconductive pads (element wiring) 506 through 509, and lead wiring (element wiring) 510 through 515, may be formed on the piezoelectric substrate 1, thereby forming a group substrate of multiple SAW elements. In the event that a group substrate of SAW elements is formed, alignment marks are also formed on the piezoelectric substrate 1. Formation of the surface acoustic wave resonators 501 through 505, electroconductive pads (element wiring) 506 through 509, and lead wiring (element wiring) 510 through 515, and alignment marks, can be performed with the same process. Subsequently, a protective film of SiN or SiO₂ or the like is preferably formed to a thickness of 5 nm for example, at the portion of the toothcomb electrodes and reflectors of the surface acoustic wave resonators 501 through 505.

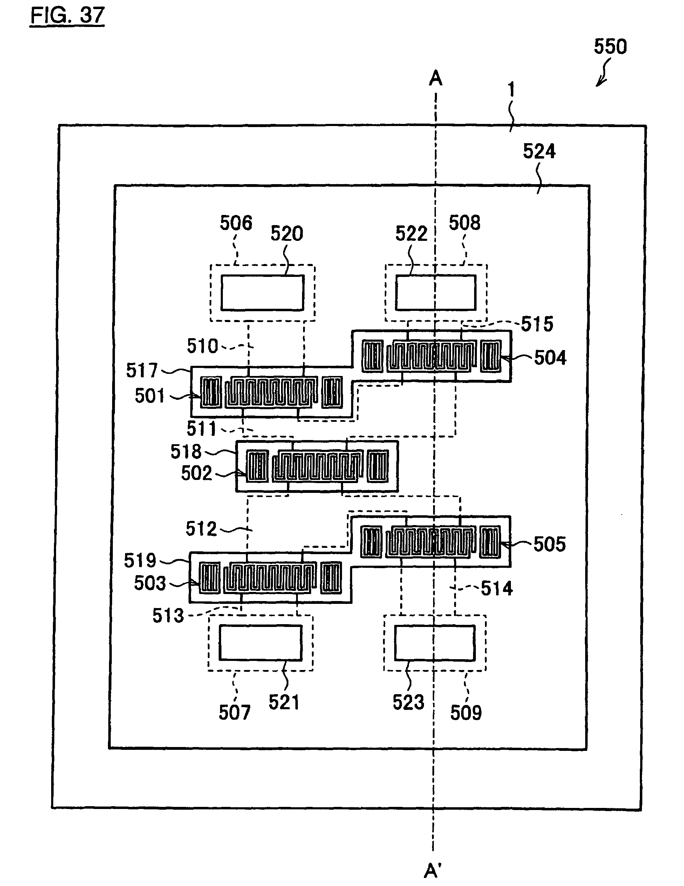

Next, as shown in Fig. 37, a resin layer 524 is formed on the SAW element 550, having resin layer openings 517 through 519 for exposing the surface acoustic wave resonators 501 through 505, and resin layer openings 520 through 523 where the electroconductive pads 506 through 509 are exposed. The resin layer 524 may cover the entire piezoelectric substrate 1.

The resin layer 524 can be formed by applying photosensitive polyimide to a thickness of 10 µm for example, and exposing and developing so as to form the resin layer openings 517 through 523. Also, the resin layer openings 517 through 523 may be formed so that not only the surface acoustic wave resonators 501 through 505 but also the nearest portions of the lead wiring 510 through 515 connected to the surface acoustic wave resonators 501 through 505 are exposed.

Also, the exposing conditions are preferably optimized at this time to make the resin openings 520 through 523 tapered shapes. Thus, latter formation of wiring and the like by metal vapor deposition or electroconductive paste at the resin layer openings 520 through 523 is facilitated.

Also, in the event that the article is a group substrate of SAW elements, dicing line portions are preferably made openings. Having no resin at the dicing line portions can suppress clogging at the time of dicing. Also, the opening width of dicing line portions is preferably equal to the width of the dicing blade.

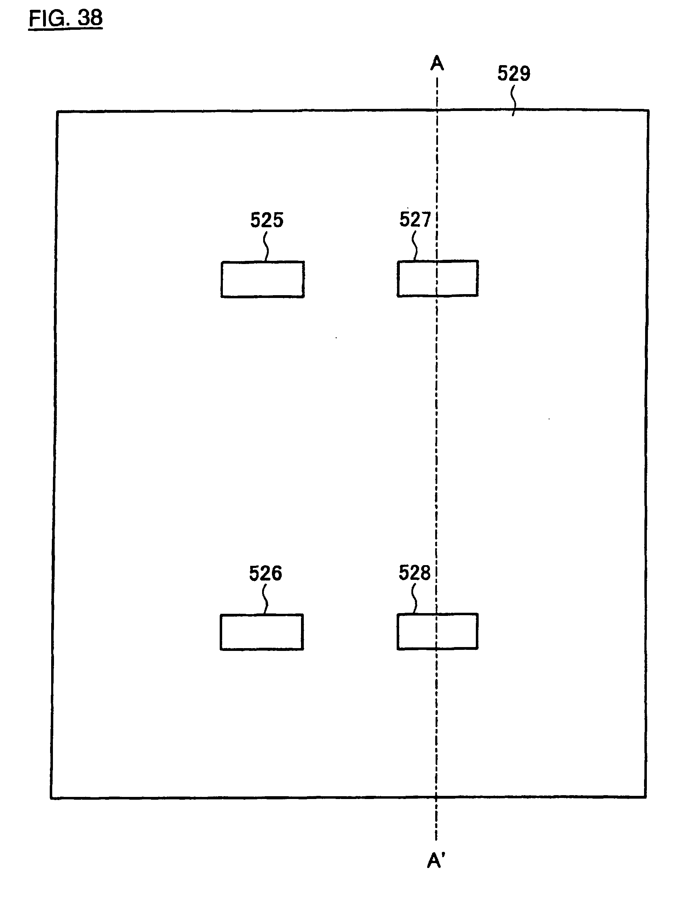

Next, as shown in Fig. 38, the bonding board 529 in which through holes 525 through 528 have been formed so that the electroconductive pads 506 through 509 are exposed through the resin openings 520 through 523, is positioned and bonded onto the SAW element 550.

At this time a glass substrate can be given as an example of the bonding board 529. A glass substrate 100 µm thick, for example, can be used. At the time of bonding, an adhesive agent is applied to the entire face of the bonding board 529 to form an adhesive layer (not shown), which is bonded to the resin layer 524, and the adhesive agent is hardened.

Also, a glass substrate may be used for the bonding board 529, with the through holes 525 through 528 being formed following bonding to the resin layer 524. In this case, patterning of the through holes and the like has not been performed to the bonding board 529 (glass substrate), so positioning is unnecessary. Also, at the time of forming the through holes 525 through 528, alignment marks on the piezoelectric substrate 1 can be used to form tapered through holes 525 through 528 in the glass substrate with laser, corresponding to the electroconductive pads 506 through 509 on the piezoelectric substrate 1. At this time, the adhesive agent is also removed by the laser. However, in this case, resist is preferably applied to the entire face of the glass substrate, and subjected to hydrofluoric acid treatment following the laser process. Processing with laser causes fused material called dross to adhere, so this is to remove that with the hydrofluoric acid.

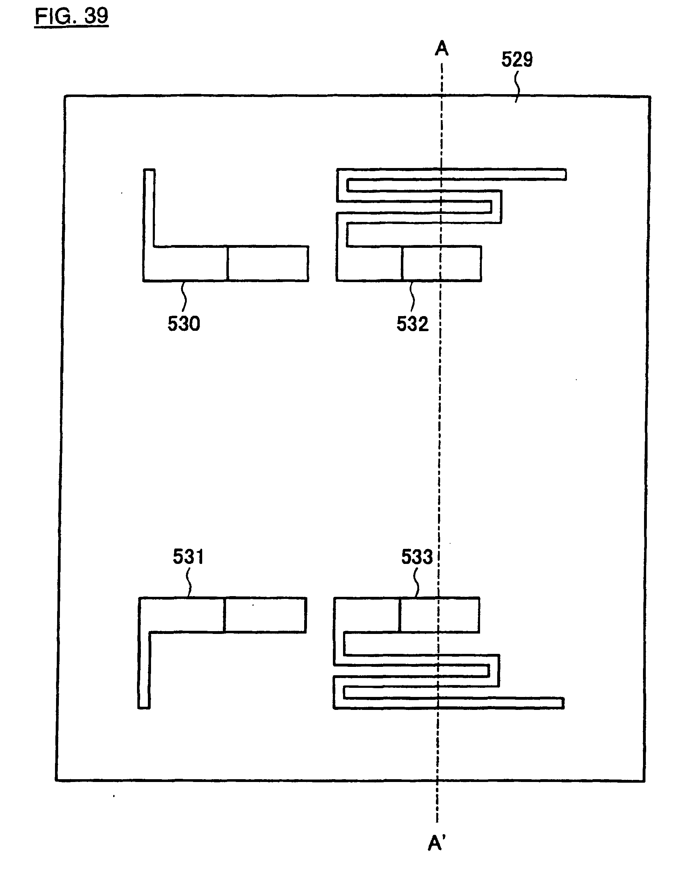

Next, as shown in Fig. 39, second wiring 530 through 533, connected to the electroconductive pads 506 through 509 via the resin openings 520 through 523 and the through holes 525 through 528, is formed on the bonding board 529. Note that the second wiring 532 and 533 is formed with inductors L. The inductors L on the second wiring 532 and 533 corresponds to the above inductors 551 and 552. While the second wiring has inductors L in the above description, the second wiring may have capacitance C as well.

The second wiring 530 through 533 can be formed on the bonding board 529 by lift-off, for example. The structure of the second wiring 530 through 533 is preferably Au (100 nm)/Ti (20 nm)/Al electrode (1 µm)/Ti (100 nm), for example.

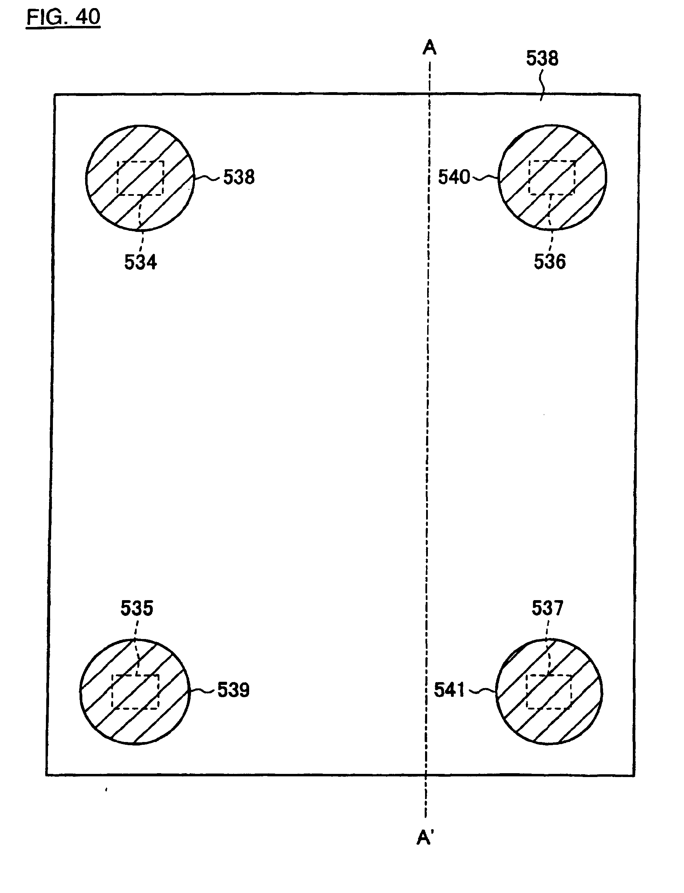

Next, as shown in Fig. 40, an upper resin layer (upper insulating layer, insulating pattern) 538 is formed on the bonding board 529, wherein are formed upper resin layer openings 534 through 537 so that the ends of the second wiring 530 through 533 are exposed. Examples of material used for the upper resin layer include photosensitive polyimide, benzo-cyclo-butene, cyclic olefin resins, epoxy resins, and the like. External terminals 538 through 541 are then formed so as to be connected to the ends of the second wiring 530 through 533 via the upper resin openings 534 through 537, thereby completing the surface acoustic wave filter 500. The portions of the external terminals 538 through 541 which are formed at the upper resin openings 534 through 537 can be considered to be external terminal connecting material. That is to say, the external terminals 538 through 541 are of a configuration wherein the external terminal connecting material and the external terminals are integrally formed. The external terminal connecting material and the external terminals may be formed by filling the upper resin openings 534 through 537 with Au-Sn solder using a printing technique, for example, and treating with heat. Also, the external terminals may be thin films formed by lift-off. Also, the external terminal connecting material and the external terminals may be separated and formed with different methods.

Further, an electroconductive resin for absorbing shock may be coated on the rear side of the piezoelectric substrate and hardened, as with the first embodiment. Or, a metal film may be formed on the rear side of the piezoelectric substrate beforehand, with the shock-absorbing resin coated thereupon. The electroconductive resin or metal exhibits electromagnetic wave shielding effects.

Also, in the event that the article is a group substrate of SAW elements, dicing is performed, thereby completing individual surface acoustic wave devices.

As described above, the position of the electroconductive pads and the external terminals can be easily offset, so the degree of freedom in design of the surface acoustic wave filter can be improved.

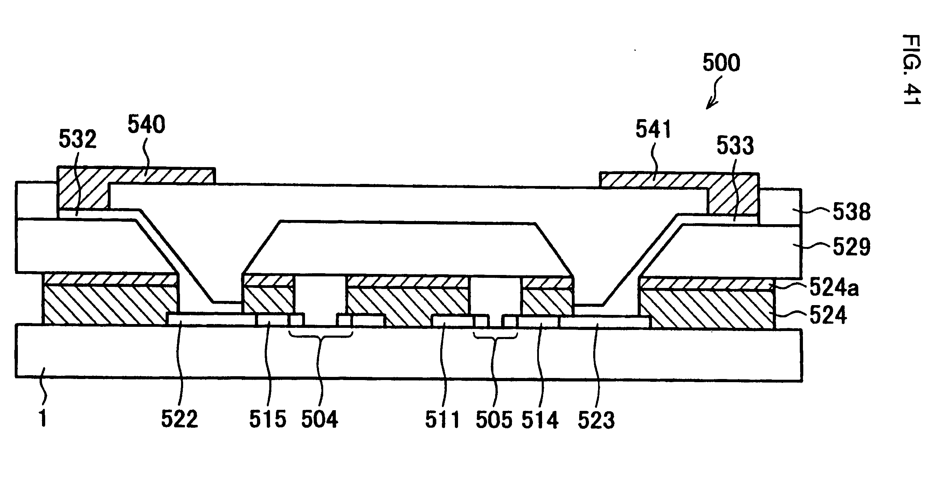

Now, a cross-sectional view along line A-A' shown in Fig. 36 through Fig. 40 of the completed surface acoustic wave filter 500 is shown in Fig. 41.

As shown in Fig. 41, an adhesive layer 324a is formed between the resin layer 524 and the bonding board 529 of the surface acoustic wave filter 500. Also, with regard to the surface acoustic wave resonators 504 and 505 of the SAW element 550, protective space for the IDTs of the surface acoustic wave resonators is ensured by the thickness of the resin layer 524. In the same way, with regard to the surface acoustic wave resonators 501 through 503 as well, protective space for the IDTs of the surface acoustic wave resonators is ensured by the thickness of the resin layer.

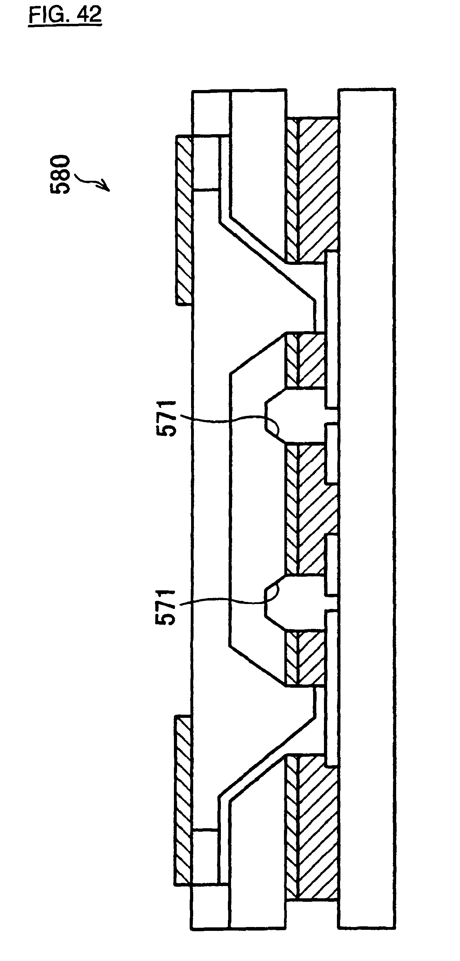

Further, a surface acoustic wave filter 580, which is a modification of the above-described surface acoustic wave filter 500, will be described with reference to Fig. 42. This surface acoustic wave filter 580 is an arrangement wherein recesses 570 and 571 are provided at portions facing the IDTs of the surface acoustic wave resonators 504 and 505 on the bonding board 529 of the surface acoustic wave filter 500. Moreover, recesses are also provided at portions facing the IDTs of the other surface acoustic wave resonators on the bonding board 529 as well.

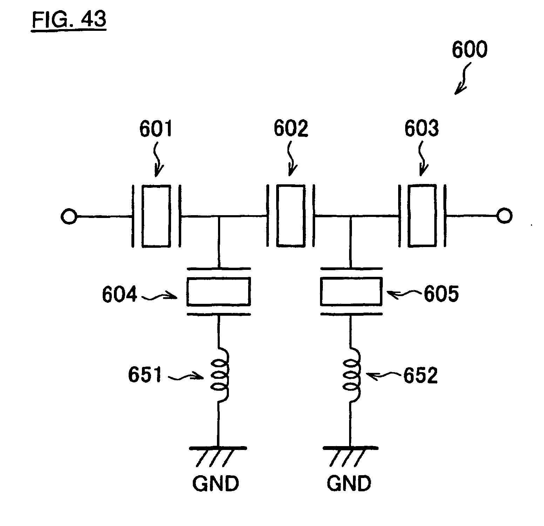

Further, a surface acoustic wave filter according to yet another specific example of the embodiment of the present invention will be described with reference to Fig. 43 through Fig. 48.

Fig. 43 illustrates a circuit diagram of a surface acoustic wave filter 600 according to the specific example. The surface acoustic wave filter 600 is of a configuration having surface acoustic wave resonators 601 through 605 having IDTs (vibrating portions) in a ladder form. Note that the surface acoustic wave resonators 601 through 603 are serial resonators, and the surface acoustic wave resonators 604 and 605 are parallel resonators, with inductors 651 and 652 being serially connected to the surface acoustic wave resonators 604 and 605.

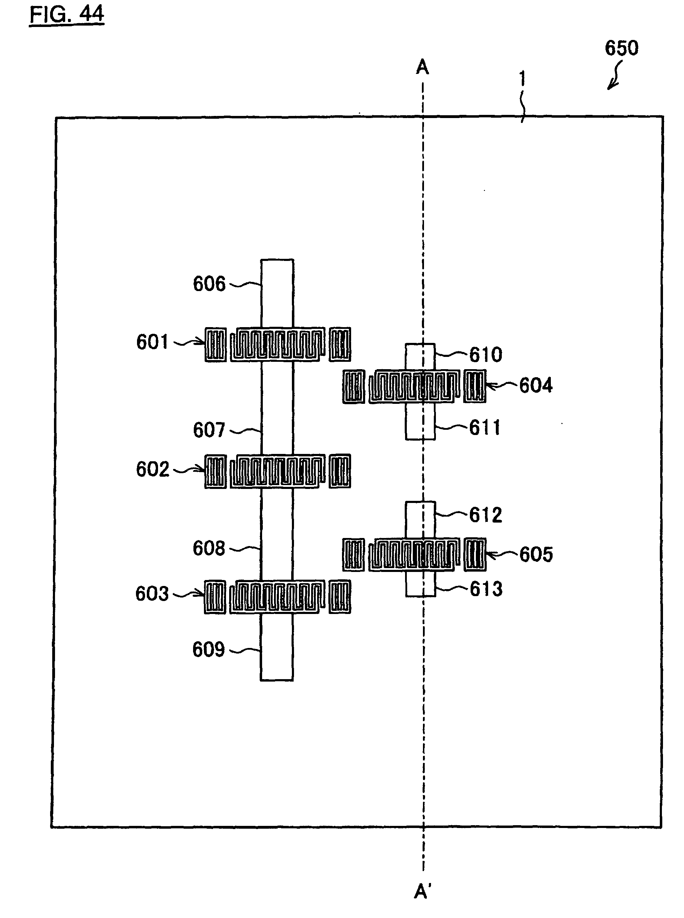

First, as shown in Fig. 44, surface acoustic wave resonators 601 through 605 and lead wiring (element wiring) 606 through 613 are formed on a piezoelectric substrate 1, thereby fabricating a SAW element 650.

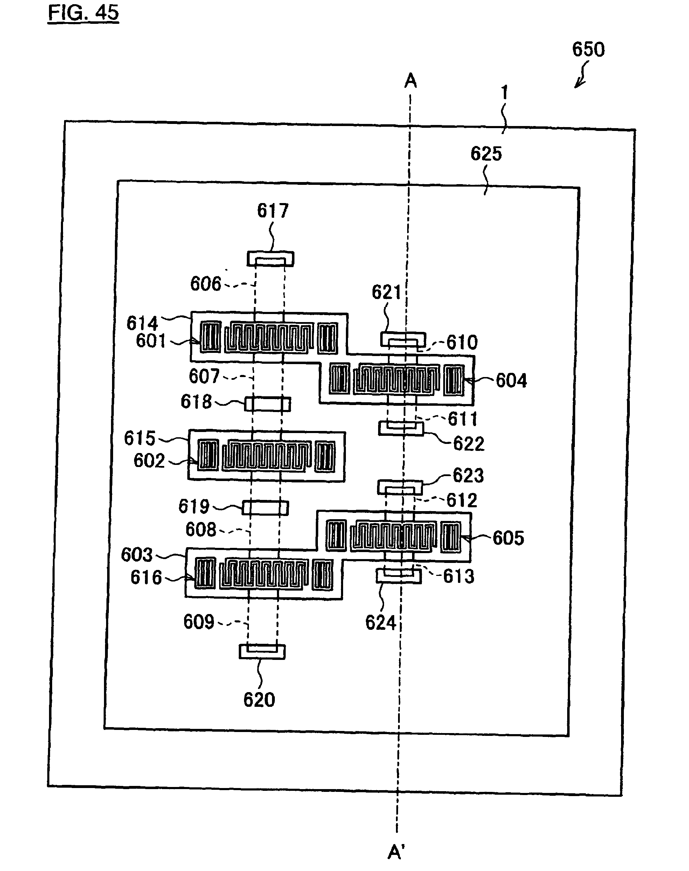

Next, as shown in Fig. 45, a resin layer 625 is formed on the SAW element 650, having resin layer openings 614 through 616 for exposing the surface acoustic wave resonators 601 through 605, and resin layer openings 617 through 624 for exposing the lead wiring 606 through 613. The resin layer 625 may also cover the entire piezoelectric substrate 1.

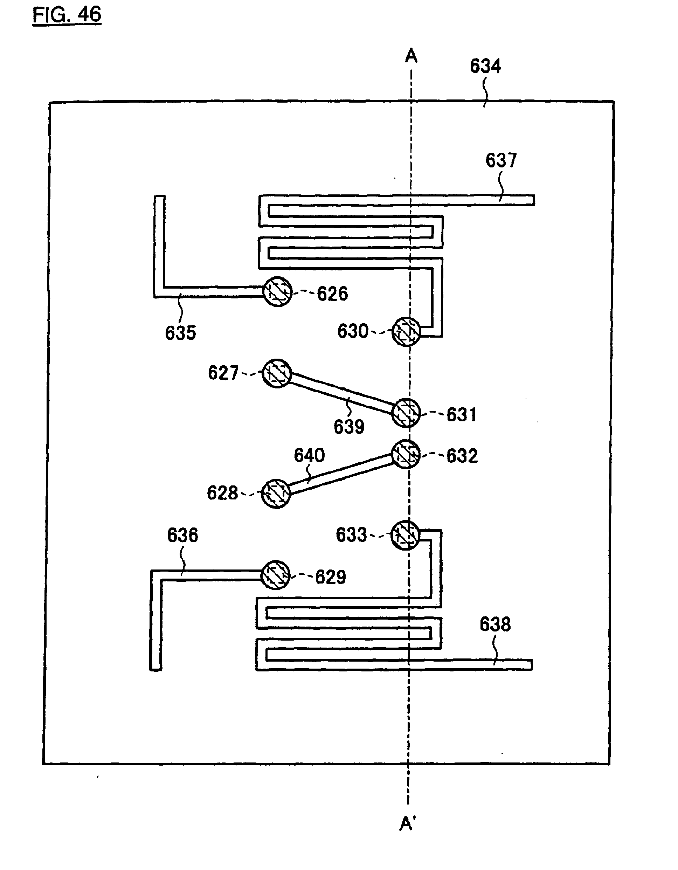

Next, as shown in Fig. 46, a bonding board 634 in which through holes 626 through 633 have been formed is positioned and bonded onto the resin layer 625 so that the lead wiring 606 through 613 is exposed via resin openings 617 through 624, thereby bonding the resin layer 325 and the bonding board 634. At this time, an unshown adhesive layer is formed on the resin layer 625. Then, second wiring 635 through 638, connected to the lead wiring 606, 609, 610, and 613 via the resin openings 617, 620, 621, and 624, and the through holes 626, 629, 630, and 633, is formed. For example, the second wiring 635 through 638 can be formed by filling in the resin openings 617, 620, 621, and 624 and the through holes 626, 629, 630, and 633 with electroconductive paste, and forming wiring with the electroconductive paste. Note that the second wiring 637 and 638 is formed integrally with inductors L. The inductors L on the second wiring 637 and 638 corresponds to the above inductors 651 and 652. While the second wiring has inductors L in the above description, the second wiring may have capacitance C as well. Further, second wiring 639, connected to the lead wiring 607 and 611 via the resin openings 618 and 622 and through holes 627 and 631, and second wiring 640, connected to the lead wiring 608 and 612 via the resin openings 619 and 623 and through holes 628 and 632, is formed.

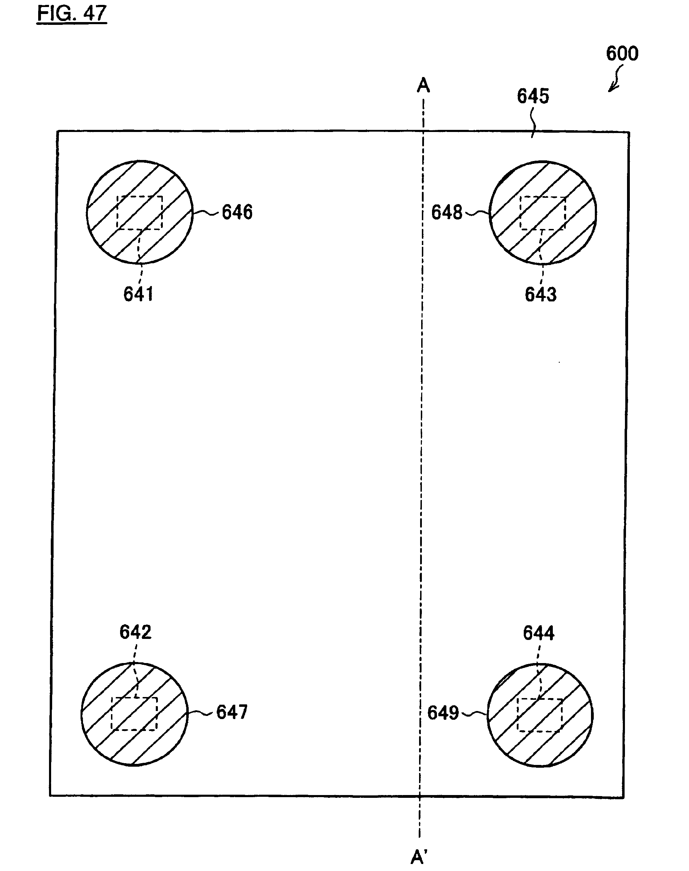

Next, as shown in Fig. 47, an upper resin layer (upper insulating layer) 645 is formed on the bonding board 625, wherein are formed upper resin layer openings 641 through 644 so that the ends of the second wiring 635 through 638 are exposed. External terminals 646 through 649 are then formed so as to be connected to the second wiring 635 through 638 via the upper resin layer openings 641 through 644, thereby completing the surface acoustic wave filter 600.

Also, in some cases, the lead wiring 606 through 613 may be formed wider, or a part of the bus bar for the surface acoustic wave resonators 601 through 605 may be formed wiring, thereby allowing the connection between the lead wiring 606 through 613, the bus bar, and the second wiring 635 through 640, to be improved.

The portions of the external terminals 646 through 649 which are formed at the upper resin layer openings 641 through 644 can be considered to be external terminal connecting material. That is to say, the external terminals 646 through 649 are of a configuration wherein the external terminal connecting material and the external terminals are integrally formed. The external terminal connecting material and the external terminals may be formed by filling the upper resin layer openings 641 through 644 with Au-Sn solder using a printing technique, for example, and treating with heat. Also, the external terminals may be thin films formed by lift-off. Also, the external terminal connecting material and the external terminals may be separated and formed with different methods.

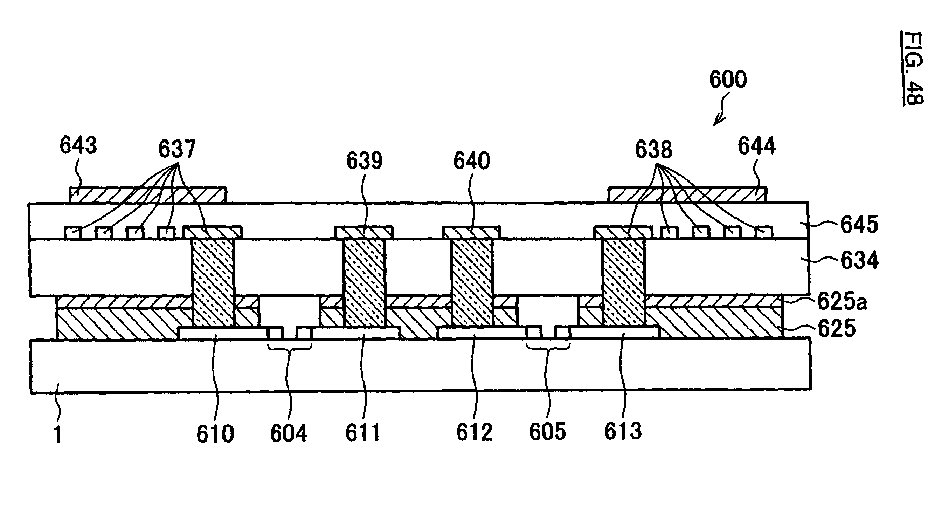

Now, a cross-sectional view along line A-A' shown in Fig. 44 through Fig. 47 of the completed surface acoustic wave filter 600 is shown in Fig. 48.

As shown in Fig. 48, an adhesive layer 625a is formed between the resin layer 625 and the bonding board 634 of the surface acoustic wave filter 600. With regard to the surface acoustic wave resonators 604 and 605 of the SAW element 650, protective space for the IDTs of the surface acoustic wave resonators is ensured by the thickness of the resin layer 625. In the same way, with regard to the surface acoustic wave resonators 601 through 603 as well, protective space for the IDTs of the surface acoustic wave resonators is ensured by the thickness of the resin layer. Also, the protective space may be ensured by providing recesses at the portions of the bonding board 634 facing the surface acoustic wave resonators 601 through 605. Also, the recesses may be formed at the same time of forming the through holes 626 through 633 in the bonding board 634.

While IDTs, reflectors, lead wiring, ad electroconductive pads are formed on the piezoelectric substrate for the surface acoustic wave filter according to the above-described first through seventh embodiments, an arrangement may be made wherein only the IDTs and reflectors are formed on the piezoelectric substrate 1. In this case, resin openings are provided in the resin layer for exposing the IDT bus bar, with the wiring being formed on the resin layer or on the bonding board. Accordingly, a part of the wiring can be done away with, thereby reducing the size of the surface acoustic wave filter.

Also, while the positions of the resin openings, through holes, and upper resin openings are offset in the above-described first through seventh embodiments, the positions of the resin openings, through holes, and upper resin openings may be matched. This does away with the electroconductive pads and a part of the wiring, thereby reducing the size of the surface acoustic wave filter.

### [Eighth Embodiment]

While a SAW element has been described as the piezoelectric element in the above-described first through seventh embodiments, a piezoelectric thin-film element may be used instead of the SAW element as the piezoelectric element in the above-described first through seventh embodiments.

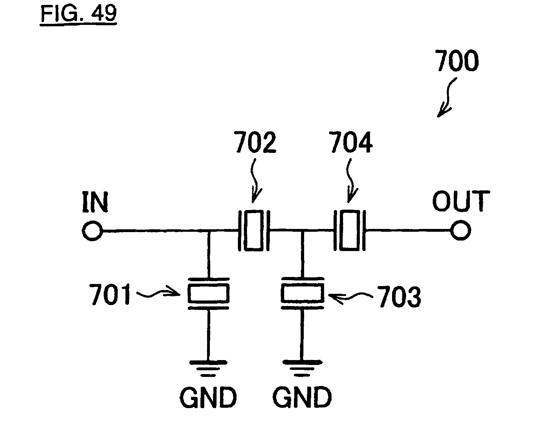

An example of a piezoelectric thin-film filter (piezoelectric part) using the piezoelectric thin-film element will be described with reference to Fig. 49 through Fig. 56.

Fig. 49 illustrates a circuit diagram of the piezoelectric thin-film filter 700 according to the present embodiment. The piezoelectric thin-film filter 700 is of a configuration having piezoelectric thin-film resonators 701 through 704 (vibrating portions) in a ladder form. Note that, with the piezoelectric thin-film filter 700, the piezoelectric thin-film resonators 701 and 703 are serial resonators, and the piezoelectric thin-film resonators 702 and 704 are parallel resonators.

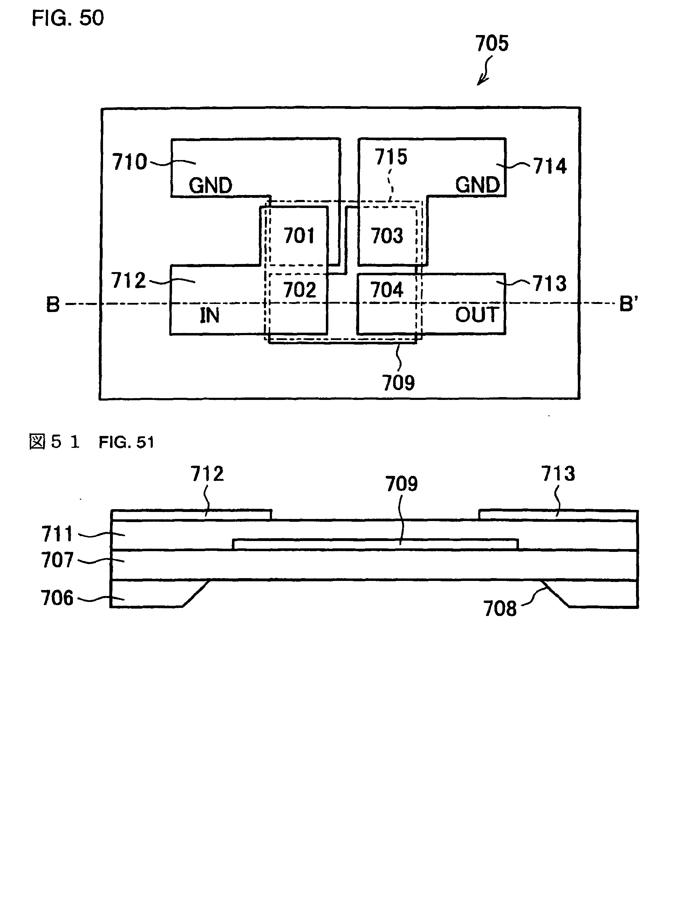

The method for manufacturing the piezoelectric thin-film filter 700 will be described with reference to Fig. 50 through Fig. 55. This manufacturing method is the manufacturing method according to the seventh embodiment, and is of a configuration wherein the piezoelectric thin-film element replaces the surface acoustic wave element.

First, as shown in Fig. 50 and Fig. 51, a piezoelectric thin-film element (piezoelectric element) 705 having the piezoelectric thin-film resonators 701 through 704 is fabricated. The piezoelectric thin-film element 705 comprises a supporting substrate 706 formed of silicon, and an insulating film 707 formed thereupon of a layer of SiO₂, SiO₂ and Al₂O₃, or a layer of Al₂O₃ and SiO₂. Further, the supporting substrate 706 has an opening (hollow portion) 708 which passes through the supporting substrate 705 in the thickness direction and reaches the insulating film 707. Also, formed upon the insulating film 707 are, in order, lower electrodes (electrodes) 709 and 710 which are formed of Al or the like, piezoelectric thin film 711 formed of ZnO or AIN or the like, and upper electrodes (electrodes) 712, 713, and 714, formed of Al or the like. The insulating film 707 forms a diaphragm. This diaphragm faces the opening (hollow portion) 708. The piezoelectric thin-film resonators 701 through 704 have a structure of sandwiching the upper and lower faces of a thin film portion having at least one layer of more of piezoelectric film on the diaphragm with a pair of lower electrode and upper electrode facing one another. With the configuration according to the present embodiment, the upper electrodes of the piezoelectric thin-film resonators 701 and 702 are integrated to form the upper electrode 712. The lower electrode 710 of the piezoelectric thin-film resonator 701 is grounded. The lower electrodes of the piezoelectric thin-film resonators 702 and 704 are integrated to form the lower electrode 709. The upper electrode 714 of the piezoelectric thin-film resonator 703 is grounded. The upper electrode of the piezoelectric thin-film resonator 704 is the upper electrode 713. Also, the dotted lone 715 indicates the diaphragm of this piezoelectric thin-film element 705. Note that the piezoelectric thin film 711 is omitted in Fig. 50.

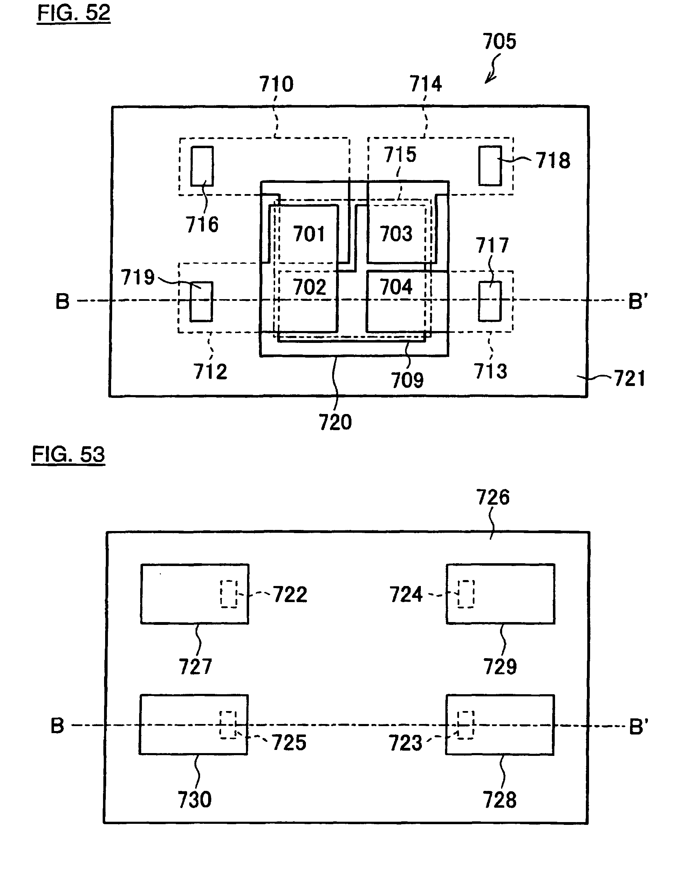

Next, as shown in Fig. 52, formed on the piezoelectric thin-film element 705 is a resin layer 721 having resin openings 719, 717, and 718, from which the upper electrodes 712, 713, and 714 are exposed, a resin opening 716 from which the lower electrode 710 is exposed, and resin openings 720 from which are exposed the piezoelectric thin-film resonators 701 through 704.

Next, as shown in Fig. 53, a bonding board 726, having through holes 725, 723, and 724, from which the upper electrodes 712, 713, and 714 are exposed through the resin openings 719, 717, and 718, and a through hole 722 through which the lower electrode 710 is exposed through the resin opening 716, is positioned and bonded to the resin layer 721 by an unshown adhesive layer. Second wiring 727 through 730 is then formed on the bonding board 726 so as to connect with the upper electrode 710, lower electrode 712, and upper electrodes 713 and 714, through the resin openings 716 through 719 and the through holes 722 through 725. Note that this second wiring 727 through 730 may have inductors L or capacitance C. Also, regarding the bonding board 726, a substrate which has a linear expansion coefficient close to that of the supporting substrate 706 is preferable, such as a hardened glass substrate, for example. A close linear expansion coefficient between the supporting substrate 706 and the bonding board 726 means that occurrence of stress, warping, and distortion can be suppressed. Accordingly, effects on the piezoelectric thin-film filter being manufactured can be suppressed, and reliability regarding changes in properties, and bonding strength, can be improved.

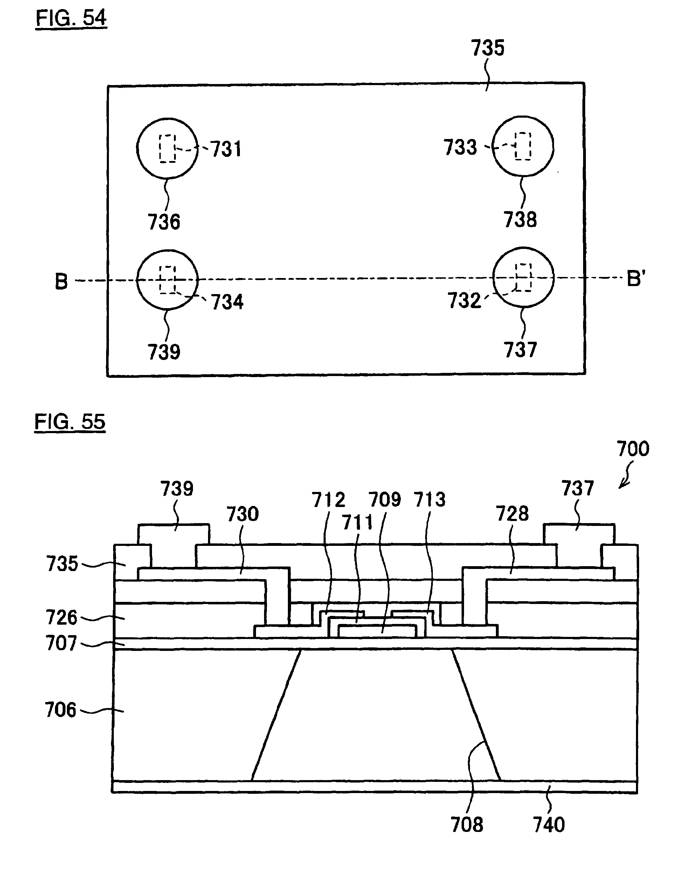

Next, as shown in Fig. 54, an upper resin layer 735 is formed on the bonding board 726, having upper resin openings 731 through 734 such that the ends of the second wiring 727 through 730 are exposed. External terminals 736 through 739 are then formed so as to come into contact with the second wiring 727 through 730 through the upper resin openings 731 through 734. Note that the portions of the external terminals 736 through 739 which are formed at the upper resin layer openings 731 through 734 can be considered to be external terminal connecting material. That is to say, the external terminals 736 through 739 are of a configuration wherein the external terminal connecting material and the external terminals are integrally formed. The external terminal connecting material and the external terminals 736 through 739 may be formed by filling the upper resin layer openings 731 through 734 with Au-Sn solder using a printing technique, for example, and treating with heat. Also, the external terminal connecting material and the external terminals 736 through 739 may be thin films formed by lift-off. Also, the external terminal connecting material and the external terminals 736 through 739 may be separated and formed with different methods.

Further, an alumina lid member for example is attached so as to cover the opening 708 of the supporting substrate 706 shown in Fig. 51, thereby completing the piezoelectric thin-film filter 700.

Now, a cross-sectional view along line B-B' shown in Fig. 50 through Fig. 54 of the completed piezoelectric thin-film filter 700 is shown in Fig. 55.

As shown in Fig. 55, with this piezoelectric thin-film filter 700, protective space for the piezoelectric thin-film resonators 702 and 704 of the piezoelectric thin-film element 705 is ensured by the thickness of the resin layer 726. In the same way, protective space for the piezoelectric thin-film resonators 701 and 703 is ensured by the thickness of the resin layer 726.

While the present embodiment describes protective space being ensured by the thickness of the resin layer, the protective space may be ensured by forming recesses in the bonding board.

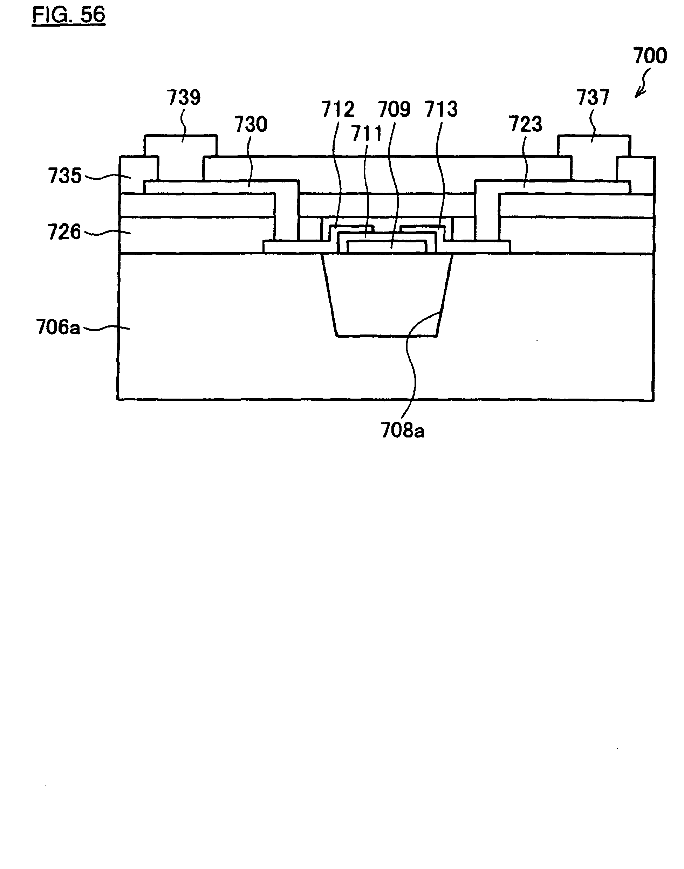

Also, as a modification of the piezoelectric thin-film filter 700, a piezoelectric thin-film filter 780 is shown in Fig. 56, for example. As shown in Fig. 56, the piezoelectric thin-film filter 780 has a configuration wherein the supporting substrate 706 of the piezoelectric thin-film filter 700 to which the opening 708 is provided, is replaced with a supporting substrate 706a in which a recess 708a has been provided. With this piezoelectric thin-film filter 780, the diaphragm can be ensured by the recess 708. Also, the diaphragm is covered by the recess 708, so there is no need to use a lid member as with the piezoelectric thin-film filter 700.

Also, as a further modification of the piezoelectric thin-film filter, an arrangement may be made for a piezoelectric thin-film resonator wherein neither opening nor recess is formed in the supporting substrate, and space is formed between the lower electrode and supporting substrate.

The present invention is not restricted to the above-described embodiments, but rather various changes may be made within the range set forth in the Claims, and further, embodiments obtained by suitably combining the technical means disclosed in different embodiments are also within the technical scope of the present invention.

### Industrial Applicability

According to the present invention, a piezoelectric part such as a surface acoustic wave device and a piezoelectric thin-film filter used for delay lines, filters, and so forth, can be reduced in size. Also, communication devices such as cellular telephones and the like using the piezoelectric part can be reduced in size.

## Claims

1. A piezoelectric part, wherein a piezoelectric element having at least one vibrating portion formed on a substrate and element wiring connected to said vibrating portion, and a bonding board having through holes, are bonded by an adhesive layer, so as to face said vibrating portion, said piezoelectric part comprising:
protective space for said vibrating portion;
wherein external terminals connected to said element wiring via external terminal connecting material formed in said through holes are at positions offset from the through holes.

2. A piezoelectric part, wherein a piezoelectric element having at least one vibrating portion formed on a substrate and element wiring connected to said vibrating portion, and a bonding board having through holes, are bonded by an adhesive layer, so as to face said vibrating portion, said piezoelectric part comprising:
protective space for said vibrating portion; and
first wiring between said adhesive layer and bonding board which is connected to said element wiring, wherein said first wiring and external terminals are connected via external terminal connecting material formed in said through holes.

3. A piezoelectric part according to Claim 2, wherein said first wiring has either capacitance or an inductor.

4. A piezoelectric part, wherein a piezoelectric element having at least one vibrating portion formed on a substrate and element wiring connected to said vibrating portion, and a bonding board having through holes, are bonded by an adhesive layer, so as to face said vibrating portion, said piezoelectric part comprising:
protective space for said vibrating portion;
second wiring on said bonding board connected to said element wiring; and
an upper insulating layer having insulating layer openings on the bonding board such that a part of the second wiring is exposed;
wherein said second wiring and external terminals formed on the upper insulating layer are connected via external terminal connecting material formed in said insulating layer openings.

5. A piezoelectric part according to Claim 4, wherein said first wiring has either capacitance or an inductor.

6. A piezoelectric part according to Claim 1, wherein said protective space is ensured by the thickness of the adhesive layer.

7. A piezoelectric part according to Claim 1, wherein said protective space is a recess formed in the face of said bonding board facing the vibrating portions.

8. A piezoelectric part according to Claim 1, wherein said adhesive layer is formed of one of thermal setting resin, thermoplastic resin, and ultraviolet setting resin.

9. A piezoelectric part according to Claim 1, wherein said adhesive layer is formed of an adhesive agent, and further comprises a resin layer between the adhesive layer formed of said adhesive agent, and the piezoelectric element.

10. A piezoelectric part according to Claim 1, wherein said bonding board is formed of a material which can be wet-etched, such as glass, quartz, fused silica, or the like.

11. A piezoelectric part according to Claim 1, wherein said piezoelectric element is a surface acoustic wave element having vibrating portions formed of toothcomb-shaped electrodes formed on a substrate.

12. A piezoelectric part according to Claim 1, wherein said piezoelectric element is a piezoelectric thin-film element having a vibrating portion with a structure wherein the upper and lower faces of a thin film portion having at least one or more layers of piezoelectric thin film, formed on the openings or recesses of a substrate having openings or recesses, are sandwiched between at least one pair of an upper electrode and a lower electrode facing each other.

13. A piezoelectric part according to Claim 1, wherein said piezoelectric element is a piezoelectric thin-film element having a vibrating portion with a structure wherein the upper and lower faces of a thin film portion having at least one or more layers of piezoelectric thin film, formed on a substrate, are sandwiched between at least one pair of an upper electrode and a lower electrode facing each other, and having a space between the substrate and the lower electrode at the vibrating portion.

14. A method for manufacturing a piezoelectric part, wherein a piezoelectric element having at least one vibrating portion formed on a substrate and element wiring connected to said vibrating portion, and a bonding board having through holes, are bonded by an adhesive layer, so as to face said vibrating portion, said method comprising:
a step for forming at least one vibrating portion on said substrate and element wiring connected to said vibrating portion to fabricate a piezoelectric element;
a step for forming through holes in said bonding board;
a step for bonding said piezoelectric element and said bonding board so as to ensure protective space for said vibrating portion with the adhesive layer;
a step for forming external terminal connection material to be connected to said element wiring via said through holes; and
a step for forming external terminals to be connected to said external terminal connection material.

15. A method for manufacturing a piezoelectric part according to Claim 14, wherein, in the step for bonding said piezoelectric element and said bonding board so as to ensure protective space for said vibrating portion with the adhesive layer, positioning is performed for said element wiring and said through holes.

16. A method for manufacturing a piezoelectric part, wherein a piezoelectric element having at least one vibrating portion formed on a substrate and element wiring connected to said vibrating portion, and a bonding board having through holes, are bonded by an adhesive layer, so as to face said vibrating portion, said method comprising:
a step for forming at least one vibrating portion on said substrate and element wiring connected to said vibrating portion to fabricate a piezoelectric element;
a step for bonding said piezoelectric element and said bonding board so as to ensure protective space for said vibrating portion with the adhesive layer;
a step for forming through holes in said bonding board;
a step for forming external terminal connection material to be connected to said element wiring via said through holes; and
a step for forming external terminals to be connected to said external terminal connection material.

17. A method for manufacturing a piezoelectric part according Claim 14, wherein recesses are formed on said bonding board so as to ensure protective space of said vibrating portion.

18. A method for manufacturing a piezoelectric part according Claim 14, wherein said through hole is formed by wet etching using a resist pattern.

19. A method for manufacturing a piezoelectric part according Claim 14, wherein said through holes are formed by laser etching or sand blasting processing.

20. A method for manufacturing a piezoelectric part according Claim 14, wherein said external terminal connection material and/or external terminals are formed by metal vapor deposition.

21. A method for manufacturing a piezoelectric part according Claim 14, wherein said external terminal connection material and/or external terminals are formed by printing an electroconductive paste and then baking.

22. A method for manufacturing a piezoelectric part according Claim 14, wherein said external terminals are formed by printing an electroconductive paste in through holes, and then forming wiring with electroconductive paste.

23. A method for manufacturing a piezoelectric part according Claim 14, wherein a group substrate having a plurality of said piezoelectric elements is formed, said bonding board is bonded to said group substrate, and then diced.

24. A method for manufacturing a piezoelectric part according Claim 23, wherein said bonding board is smaller than said group substrate.

25. A method for manufacturing a piezoelectric part according Claim 14, wherein said piezoelectric element is a surface acoustic wave element having vibrating portions formed of toothcomb-shaped electrodes formed on a substrate.

26. A method for manufacturing a piezoelectric part according to Claim 14, wherein said piezoelectric element is a piezoelectric thin-film element having a vibrating portion with a structure wherein the upper and lower faces of a thin film portion having at least one or more layers of piezoelectric thin film, formed on the openings or recesses of a substrate having openings or recesses, are sandwiched between at least one pair of an upper electrode and a lower electrode facing each other.

27. A method for manufacturing a piezoelectric part according to Claim 14, wherein said piezoelectric element is a piezoelectric thin-film element having a vibrating portion with a structure wherein the upper and lower faces of a thin film portion having at least one or more layers of piezoelectric thin film, formed on a substrate, are sandwiched between at least one pair of an upper electrode and a lower electrode, and having a space between the substrate and the lower electrode at the vibrating portion facing each other.
